Europäisches Patentamt

European Patent Office

Office européen des brevets

(19)

(11) **EP 0 444 875 B1**

(12) # EUROPEAN PATENT SPECIFICATION

(45) Date of publication and mention
of the grant of the patent:
**14.05.1997 Bulletin 1997/20**

(51) Int Cl.6: **G01R 13/34**, G01R 13/32

(21) Application number: **91301535.0**

(22) Date of filing: **26.02.1991**

(54) **Method and apparatus for increasing throughput in random repetitive digitizing systems**

Verfahren und Anordnung zur Vergrösserung des Durchsatzes in Zufallsfolge zyklischer Digitalisierungssysteme

Procédé et dispositif pour augmenter la preformance des systèmes numériques à répétition au hasard

(84) Designated Contracting States:
**DE FR GB**

(30) Priority: **02.03.1990 US 487685**

(43) Date of publication of application:
**04.09.1991 Bulletin 1991/36**

(73) Proprietor: **Hewlett-Packard Company
Palo Alto, California 94304 (US)**

(72) Inventor: **Montijo, B. Allen
Colorado Springs, Colorado 80920 (US)**

(74) Representative: **Colgan, Stephen James et al
CARPMAELS & RANSFORD
43 Bloomsbury Square
London WC1A 2RA (GB)**

(56) References cited:
**EP-A- 0 181 565      EP-A- 0 310 249
US-A- 4 678 345**

• **HEWLETT-PACKARD JOURNAL. vol. 37, no. 4,
April 1986, PALO ALTO US pages 26 - 32; SCOTT
ET AL.: 'HARDWARE IMPLEMENTATION ...'**

## Description

This invention relates to methods and apparatus for increasing throughput in systems which sample repetitive signals. More specifically, this invention is directed to random repetitive signal acquisition systems which utilize trigger and trigger qualifying circuitry.

Background of the Invention

The oscilloscope has been a tool of technicians, engineers and designers for analyzing time domain signals for over forty years. Typically, oscilloscopes analyze electrical signals and display the signals on a CRT screen as a function of amplitude (e.g., voltage magnitude) versus time. An oscilloscope combines the time measurement abilities of a frequency counter with the amplitude measurement capabilities of a multimeter to provide useful information concerning the electrical signal of interest.

The oscilloscope thus aids circuit designers in qualifying the performance of a new circuit or any circuit under test. Previously, oscilloscopes were generally analog in nature. In an analog oscilloscope, a signal enters through an attenuator which is generally a variable resistive-divider network. The attenuator brings the input signal to within an input operating range of a preamplifying circuit ("preamp").

The preamp and the attenuator scale the signal and apply any gain factors which are desired for the particular application and circuit being examined. The preamp circuit also drives a multiplexer which then drives a voltage amplifier and ultimately drives the vertical sweep of the cathode ray tube (CRT). Additionally, the preamp provides high to low impedance conversion so that the analog oscilloscope can be made virtually noise-free.

The trigger circuitry in the analog oscilloscope is operatively coupled to the horizontal sweep circuit of the CRT. The trigger circuit activates the horizontal sweep of the CRT when the trigger circuit acquires a trigger signal. The trigger signal is generally acquired from the input signal through a trigger comparator circuit which outputs a pulse when some predetermined trigger criteria are satisfied. The trigger pulse starts a capacitive charge that ramps a voltage level. This causes the beam in the CRT to move across the screen horizontally and thus display the signal characteristics of the input signal as a function of voltage versus time.

The ramp voltage which generates the horizontal sweep is typically obtained from a charging capacitor. However, in the real world it is difficult to linearly charge a capacitor with a current source to within acceptable high accuracy. Furthermore, capacitive charging is usually not constant and, thus, creates inaccuracies in the sweep. These factors contribute to inaccuracy in timing measurements.

The inaccuracy in timing measurements in typical analog oscilloscopes is about 3% of full scale. As an example of the timing measurement inaccuracies encountered with an analog oscilloscope, consider measuring a 2 nanosecond (ns) pulse width at 1 ns per division on the screen of a scope. The accuracy of this measurement is thus 0.3 ns or 15% timing error. Thus, analog oscilloscopes do not satisfy a long-felt need in the art for devices which can measure signal characteristics with high accuracy.

Additionally, factors besides the gain error must be taken cumulatively into account in order to make accurate voltage measurements with an analog oscilloscope. Analog oscilloscopes also exhibit significant position and parallax errors which reduce voltage measurement accuracy. Other factors, such as low storage tube capability and large bandwidth rolloff also contribute significantly to inaccurate voltage measurements with an analog oscilloscope. Analog oscilloscopes thus cannot satisfy a long-felt need in the art for measurement systems which provide highly accurate voltage and time measurements of electrical signals.

Digitizing or "digital" oscilloscopes have been developed to solve some of the aforementioned problems exhibited with analog oscilloscopes. For example, a typical digitizing oscilloscope's timing error is about 0.002% of full scale. A digitizing oscilloscope exhibits superior timing error with respect to the 3% typical timing error in an analog oscilloscope by using a crystal timebase instead of a charging capacitor and ramp voltage in the horizontal sweep circuitry. Other advantages such as the elimination of parallax error can be achieved with a digitizing oscilloscope.

Typically, a digitizing oscilloscope uses the same type of trigger comparator circuitry as found in an analog oscilloscope. Furthermore, similar attenuation and preamplifying inputs as found on the vertical paths of an analog oscilloscope may be provided for each channel of information on a digital oscilloscope. However, with a digitizing oscilloscope it is not necessary to use a multiplexer on the vertical paths. Digitizing oscilloscopes also operate in a significantly different fashion than analog oscilloscopes in acquiring and displaying data. A digitizing oscilloscope uses an analog-to-digital converter (ADC) which converts scaled, impedance converted analog data into digital words. The digital words are then stored in an acquisition memory so that they may be bused to a central processing unit (CPU) or microprocessor for eventual display on a CRT screen or use in other data acquisition and manipulation systems.

The ADC digitizes the analog signal data which comes over the various input channels. The digital information is then typically stored in a memory which may be, for example, a ring memory structure. A ring memory begins filling memory with data words at some location and continues adding more words around the ring. Ring memories offer an advantage when used in digitizing oscilloscopes since a full ring of digitized data taken prior to the trigger event is available to the system when "negative time," i.e. events which happen before a trigger, data acquisition is accomplished. The typical memory length for each digital ring in a digital oscilloscope is from 1 to 2 kbytes.

A crystal timebase, generally a clock circuit, updates the CPU in the digitizing oscilloscope and informs the CPU where in the ring memory the trigger event has occurred. The crystal provides accurate and stable timing for the digitising oscilloscope. Circuitry in the crystal timebase determines the timing between the asynchronous trigger event and the next sample point because a trigger event can occur between sample points, not necessarily on a sample point. Since the sample clock and the timebase are derived from a crystal oscillator, the timing accuracy of a digitizing oscilloscope is very good; typically around 0.002%.

In an analog oscilloscope, the trigger event is always at the farthest point on the left-hand side of the CRT screen. However, in a digitizing oscilloscope the trigger event may be placed at the center of the CRT screen. Thus, with a digitizing oscilloscope the user sees half of the screen in a pre-trigger time, and half of the screen in a post-trigger time. A control is provided to the digitizing oscilloscope which allows the trigger event to be moved from left to right on the CRT screen by the user. This ability to alter the position of the trigger on the CRT screen provides a significant advantage over displays on analog oscilloscopes since it is possible to home in on a particular event around the trigger reference point on the CRT screen with a digitizing oscilloscope.

Generally, there are two ways to acquire digitized data with a digitizing oscilloscope. The first way is by real time acquisition, sometimes referred to as "single-shot sampling". Single shot sampling digital oscilloscopes sample an input waveform as fast as the ADC in the oscilloscopes sample and acquire all of the digitized data on a single trigger. State-of-the-art digitizing oscilloscopes using single-shot sampling data acquisition generally allow about one "Giga sample" (GSa/s) per second at 6 to 8 bits resolution. Single-shot sampling is possible with both repetitive and non-repetitive signals. However, single-shot digitizing oscilloscope are generally much more expensive than other types of digitizing oscilloscopes.

Single-shot data acquisition digitizing oscilloscopes exhibit significant disadvantages to digitizing oscilloscopes which utilize other types of sampling. For example, it is very easy to miss glitches between sampling points with a single-shot digitizing oscilloscope. These high-frequency glitches are also missed when a similar bandwidth analog oscilloscope is used. Additionally, the bandwidth of a single-shot oscilloscope is limited by the sampling frequency. Furthermore, the timing resolution of a single-shot digitizing oscilloscope is limited by the speed of the ADC. Thus, single-shot sampling digital oscilloscopes do not satisfy a long-felt need in the art for digital oscilloscopes which provide accurate and efficient analysis of electrical input signals.

The second way in which data may be acquired by a digitizing oscilloscope is with "repetitive sampling." Repetitive sampling is used when a repetitive waveform is present. As known by those skilled in the art, a repetitive waveform is any waveform which has a regular period. Repetitive sampling systems do not make single-shot measurements well because they are designed with slower ADCs. This allows better vertical resolution of the repetitive signal. An example of a digital oscilloscope which utilizes both single-shot and repetitive sampling in two different modes is the HP 54111D digital oscilloscope available from the Hewlett-Packard Company, Palo Alto, California.

There are essentially two kinds of repetitive sampling used by digital oscilloscopes. The first kind of repetitive sampling is called "sequential repetitive sampling". In sequential repetitive sampling, only one sample of the signal is digitized on each occurrence of the trigger signal. With each successive trigger, the sampling point is delayed further from the trigger point. After many samples are acquired and digitized, the signal is reconstructed in the oscilloscope's digital memory. Sequential sampling works by delaying data acquisition by a specified amount of time after the trigger event occurs, then taking a sample. The amount of the delay starts at zero seconds and evenly increments depending on the capability of the digitizing oscilloscope.

With sequential repetitive sampling, timing resolution is excellent compared to real-time, single-shot sampling in digitizing oscilloscopes. Additionally, sequential sampling does not miss glitches unless the glitches occur in time periods less than the sampling delay resolution of the timebase. Furthermore, the bandwidth in a digitizing oscilloscope utilizing sequential repetitive sampling is not limited by the sampling frequency, but rather is merely limited by the particular capabilities of the preamplifiers and attenuators in the front end of the digital oscilloscope.

However, there are several disadvantages inherent in sequential repetitive sampling digital oscilloscopes. The first of these disadvantages is the need to wait for a trigger signal before the sample is taken which does not provide the desirable capability of viewing negative time without a delay line. Furthermore, there is no single-shot capability with sequential sampling because each sample point requires a full trigger event. Additionally, with slow repetition signals, triggers occur slowly, and thus, acquisition of a complete representation of the signal for display takes a long time to complete.

The second type of repetitive sampling is called "random repetitive sampling." In random repetitive sampling, the ADC is always sampling at the same rate. Thus depending upon the "samples per division" (Sa/DIV) of the screen, a different number of samples per trigger may be obtained. The waveform in random repetitive sampling is built up over multiple trigger acquisitions. Random repetitive sampling is denoted as "random" since the trigger event is asynchronous with respect to the sample clock. This means that each trigger yields a group of samples that are shifted in phase between other groups of samples. After each acquisition, the data collected on that acquisition is time correlated by a time interpolator to the trigger event and to the older data points acquired and placed on the screen. Random repetitive sampling is dissimilar to sequential repetitive sampling to the extent that the signal is constantly being sampled and digitized at a rate determined by the digital oscilloscope sampling clock.

Random repetitive sampling provides several advantages over sequential sampling. In random repetitive sampling digital oscilloscopes, the user can view sampling in negative time without the need for a delay line. Furthermore, random repetitive sampling digital oscilloscopes exhibit higher throughput at lower sweep speeds as compared to sequential sampling digital oscilloscopes.

However, random repetitive sampling exhibits significant problems when a digital oscilloscope samples high frequency input signals. At fast sweep speeds, the probability of acquiring a small display window is reduced as compared to acquiring a small display window in a sequential repetitive sampling system. Therefore, the throughput of random repetitive sampling digital oscilloscopes is reduced at fast sweep speeds. Thus, random repetitive sampling digitizing oscilloscopes do not have optimal throughput when a user needs fine time resolution for a measurement. As used herein, the term "fine time resolution" is defined with respect to the actual sample rate of the instrument being used.

This point may be illustrated by the following example. Consider a random repetitive acquisition system where the actual sample rate is 40 MHz and the screen width is 1 ns (100 psec/DIV). The time between samples is thus 1/40 MHz which is equal to 25 ns -- 25 times as large as the time interval being examined. Since the system is sampling randomly with respect to the signal, the system is also sampling randomly with respect to the trigger. The trigger can thus occur anywhere within the 25 ns sampling interval and there will be a probability of 1/25 that a sample will fall within the 1 ns screen window. Therefore, on the average, only one in 25 acquisitions results in a usable sample.

This is a poor result because the overhead time required to perform an acquisition is not negligible. It takes on the order of microseconds to determine if any of the sample points actually fall on the screen and to begin a new acquisition. In modern random repetitive acquisition systems in digitizing oscilloscopes, there is no previously known information about the signal and thus no possibility of changing the probability of 1 out of 25 that a trigger will generate a point on the screen.

If, for example, the triggers are occurring at a 15 MHZ rate, a trigger period of 67 ns is achieved. After the system begins to look for a trigger, the average time to find a trigger is approximately one-half of 67.0 ns, or 33.5 ns. If one assumes an acquisition overhead time of about 6.0 μs, which is typical for a modern, state-of-the-art digitizing oscilloscopes, it takes approximately an average of:

$$25 \text{ acquisitions} \times (6.0 \text{ μs} + 1/2 \times 67.0 \text{ ns}) = 150.8 \text{ μs},$$

to acquire a usable sample. This time period occurs since, for every acquisition of data, a 6.0 μs overhead period during which the CPU determines whether that trigger has resulted in a usable sample is tacked on to the acquisition time. This is a highly inefficient way to acquire samples and requires the microprocessor in the digitizing oscilloscope to spend an inordinate amount of processor time in determining whether each acquisition has resulted in usable data. If this acquisition time could be reduced or eliminated for any trigger which does not acquire a useable sample, the throughput of the system could be greatly increased and the microprocessor freed to perform other tasks during the acquisition procedure. Modern random repetitive signal acquisition systems cannot reduce or eliminate this problem.

Present random repetitive sampling digitizing oscilloscopes and systems thus do not fulfill a long-felt need in the art for random repetitive sampling acquisition systems which minimize the reduction in throughput of the system as the sweep speed is increased. Previous trigger detection circuits in random repetitive data acquisition digitizing systems do not -- and cannot -- enhance efficiency in random repetitive sampling systems and provide increased throughput. A long-felt need in the art therefore exists for trigger qualifying systems and circuitry in random repetitive acquisition systems which increase system throughput and provide more efficient use of microprocessing time.

In an article by S.A. Genther and E.A. Evel, entitled "Hardware Implementation of a High-Performance Trigger System" (Hewlett-Packard Journal, Vol. 37, No. 4, April 1986, pages 26-32), there are described digitising oscilloscopes providing triggering capabilities which are structured into modes. Only one mode is active at a time, and, in one oscilloscope described, the modes are edge, pattern, state, time delay and event delay.

US-A-4 678 345 describes a system for sampling a repetitive waveform in each of several narrow acquisition windows bounding repetitive sections of the waveform in order to obtain equivalent time sample data characterising the shape of the waveform included within the acquisition windows. The period between successive triggering events is measured, and sampling is delayed following an initiating triggering event by a delay time adjusted according to the measured period so as to maximise the probability that sampling will occur within an acquisition window.

EP-A-0 181 565 describes a digital oscilloscope comprising a circuit for detecting inaccurate reconstructions of waveforms. The fundamental frequency of the input signal under test is determined by a frequency-determining circuit and compares with the sampling frequency. The sampling rate can be increased in response to the occurrence of the alias flag signal to ensure accurate reconstruction of the waveform on the display means of the oscilloscope.

## Summary of the Invention

Circuits for increasing throughput in a random repetitive signal acquisition system of the type which uses triggers, wherein the circuit allows the random repetitive signal acquisition system to terminate an acquisition only when there is a high probability that usable samples have reached the system, are provided in accordance with the present invention as defined by the claims. The circuits may comprise logic means for producing a qualifier signal having at least two input ports, first means coupled to a first input port of the logic means for introducing a first delay in a sample signal, thereby producing a first delayed sample signal for setting the logic means and enabling the qualifier signal, and second means coupled to a second input port of the logic means for introducing a second delay in a sample signal, thereby producing a second delayed sample signal for resetting the logic means and disabling the qualifier signal.

A method of arming a trigger circuit in a random repetitive signal acquisition system in accordance with the invention comprises the step of producing a sample signal having a sample period. The sample signal is preferably delayed for a time, thereby producing a delayed sample signal. A periodic qualifier signal is then produced from the delayed sample signal and the trigger circuit is armed periodically with the periodic qualifier signal.

## Brief Description of the Drawings

Figure 1 is a functional block diagram of a digitizing oscilloscope provided in accordance with this invention having trigger qualifier circuitry which increases the throughput of the system.

Figures 2A and 2B are circuits for producing qualifier signals provided in accordance with this invention.

Figures 3A and 3B are circuits for producing variably delayed signals for use in the circuits of Figures 2A and 2B.

Figure 4 is a circuit for producing a qualified trigger signal in accordance with this invention.

Figure 5 is a timing diagram of the signals present in the circuit of Figure 4.

Figure 6 is a circuit for producing a qualifier signal provided in accordance with this invention using linear integrated circuits to produce variable delays.

Figure 7 is a timing diagram of the signals present in the circuit of Figure 6.

Figure 8 shows an implementation in accordance with the invention of a qualified trigger arm signal from an existing trigger arm signal and a trigger qualifier signal.

Figure 9 illustrates a preferred embodiment of a circuit provided in accordance with the invention for producing a qualified trigger signal.

Figure 10 is a flow chart illustrating a preferred embodiment of a method for calibrating a random repetitive signal acquisition system.

Figure 11 is a flow chart illustrating a preferred embodiment of a method of building a histogram to convert delay values to programming values for the start and stop time delay generators' digital to analog converters in a random repetitive signal acquisition system.

## Detailed Description of Preferred Embodiments

Methods and apparatus provided in accordance with this invention provide trigger qualifying circuitry for any digitizing system which utilizes random repetitive data acquisition and sampling. In preferred embodiments, methods and apparatus provided in accordance with this invention are particularly useful for increasing throughput in digitizing oscilloscopes which utilize random repetitive signal acquisition.

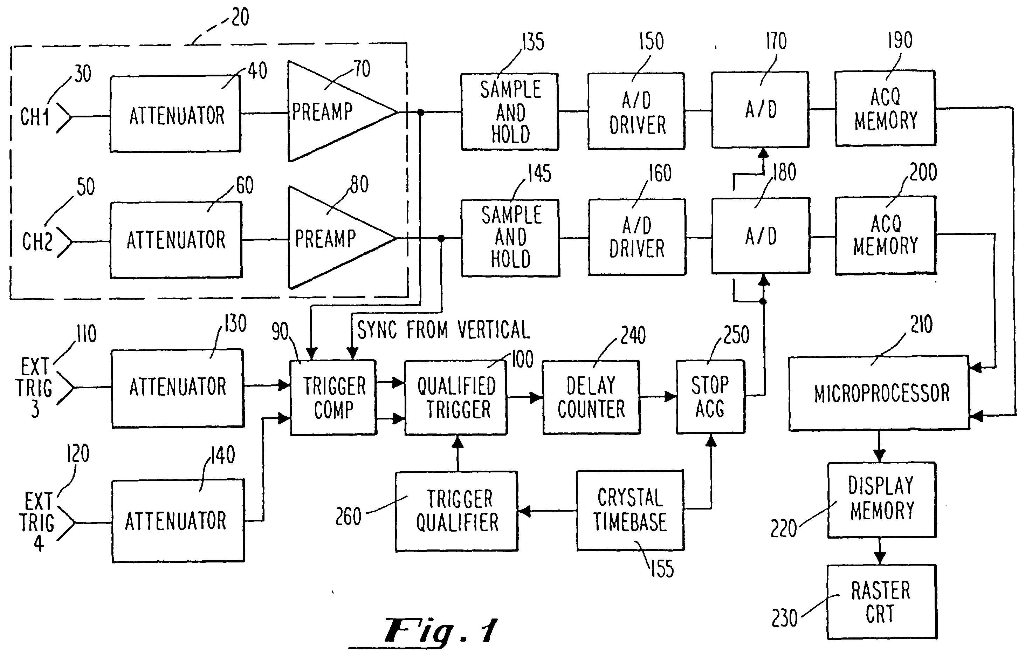

In Fig. 1, a functional block diagram of a digitizing oscilloscope provided in accordance with this invention having trigger qualifying circuitry which increases the throughput of the digitizing oscilloscope is shown. Present digitizing oscilloscopes may be modified with circuitry provided in accordance with this invention to obtain qualified triggers and increased throughput. In general, the HP 54100 family of digitizing oscilloscopes available from the Hewlett-Packard Company, Palo Alto, California, are readily available for such modification.

The front end 20 of the digital oscilloscope is similar to the front end of most standard analog oscilloscopes. In a preferred embodiment, four channels of information in a vertical path are available for simultaneous acquisition. For ease of illustration, two channels are shown. The signal on channel one, shown at 30, enters an attenuator 40. Similarly, a signal on channel two at 50 enters an attenuator 60.

The attenuators 40 and 60 are generally comprised of variable resistive divider networks which bring the input signal to within the input operating range of preamplifiers 70 and 80. Preamplifiers 70 and 80 work in conjunction with the attenuators 40 and 60 respectively to scale the signal available on channels 30 and 50. In further preferred embodiments, it is possible to have variable gain in preamps 70 and 80. The preamps 70 and 80 also provide trigger comparator circuit 90 with synchronous pulses from the vertical signals coming through over channels 30 and 50. Generally, in previous digital oscilloscopes, trigger comparator 90 is activated on an edge of the signal when one of the channels has a signal which is above some predetermined limit, generally a voltage level.

Trigger comparator 90 inputs signals to qualified trigger circuit 100 when one of the inputs from external triggers 110 or 120 falls above this predetermined voltage level. Qualified trigger 100 qualifies an event, for example a sample signal, before the event actually triggers the digitizing oscilloscope. Attenuators 130 and 140 scale the trigger signals 110 and 120 which are external trigger inputs that cannot be viewed but which may allow the user to view some other event. In preferred embodiments, the trigger comparator circuit is activated on an edge of the repetitive input signal. In still further preferred embodiments, trigger comparator circuit 90 is triggered on a positive edge of the repetitive input signal.

In digitizing oscilloscopes, the input signal or waveform is quantized into discrete time and voltage samples. In repetitive acquisition systems, "sample and hold" circuitry is provided so that signals appearing over channels 30 and 50 can be regularly digitized. Sample and hold blocks 135 and 145 are thus coupled to preamps 70 and 80 respectively. Sample and hold blocks 135 and 145, in preferred embodiments, comprise a sampling clock having a regular periodic frequency. The sampling clocks sample at a constant rate which is dependent upon the particular capabilities of crystal timebase circuitry 155 provided to the digitizing oscilloscope. In preferred embodiments, the sample rate is 40 MHz. It will be recognized by those with skill in the art that other sample rates may be available depending upon the capabilities of the particular analog to digital converters in the digitizing oscilloscope, and the particular applications which will be encountered by the digitizing oscilloscope.

Analog to digital (A/D) driver circuits 150 and 160 are respectively coupled to the outputs of the sample and hold blocks 135 and 145. The A/D drivers 150 and 160 drive a pair of A/D converters 170 and 180 respectively. A/D converters 170 and 180 digitize the analog data coming over channels 30 and 50. The digital information from A/D converters 170 and 180 are then stored in acquisition memories 190 and 200 respectively. In preferred embodiments, acquisition memory depth is from 1-2 k-words in length.

Microprocessor 210 is interfaced with acquisition memories 190 and 200. The microprocessor receives user commands and controls the data acquisition circuitry. The microprocessor 210 collects the data from the data acquisition memories 190 and 200 and displays the data through display memory 220 on a CRT screen 230. The vertical path of the digital oscilloscope can be considered to end with acquisition memories 190 and 200. In preferred embodiments, the vertical path thus synthesizes digital words which correspond to voltage levels in the signal coming over channels 30 and 50.

The data may then be written to the CRT screen memory or buffer. The screen memory is written asynchronously with respect to the CRT beam to the buffer by the microprocessor. The "horizontal sweep" of the digitizing oscilloscope begins when qualified trigger circuit 100 senses an edge signifying a random repetitive signal which should be displayed. Qualified trigger circuit 100 is interfaced with a delay counter 240 which is further interfaced with stop circuitry 250 that communicates with the ADCs 170 and 180 and causes the ADCs to cease acquiring and digitizing data.

In accordance with the present invention, trigger qualifier circuitry 260 is provided having an input from timebase 155. It will be appreciated that trigger qualifier circuit 260 may be part of trigger comparator block 90 such that a circuit block comprising trigger qualifier circuit 260 and qualified trigger circuit 100 outputs an edge or pulse when the input meets some user defined criteria. In preferred embodiments, the event may be a positive edge of the input signal having a predetermined high voltage level. Trigger qualifier circuitry 260 provided in accordance with this invention arms qualified trigger circuit 100 such that the overall throughput of the digitizing oscilloscope is increased.

The crystal timebase 155 and trigger qualifier circuit 260 are set by the user to give the screen width a predetermined value. In preferred embodiments, the screen width is one ns. In further preferred embodiments, the trigger from circuit 100 is set to be 100 psec from the left of the screen. Thus, any sample taken from 100 psec before the trigger to 900 psec after the trigger will lie on the screen. This means that any trigger occurring from 900 psec before the sample to 100 psec after the sample will result in the sample being usable. Thus, trigger qualifying circuit 260 defines a window, with respect to the sample clock in the crystal timebase 155, which determines usable triggers.

In order to make trigger qualifier circuitry 260 functional for a wide range of input signals, trigger qualifier 260 should be flexible, having different start and stop delay settings which may be adjusted by the user microprocessor, or by the user from the digital oscilloscope control panel. In preferred embodiments, the trigger window width should be variable from the minimum screen width up to about the sample clock period. Furthermore, the trigger window's position should be movable to any time position in the sample clock period.

Trigger qualifier circuit 260 forces a trigger enable window to appear within each sample clock period and allows the digitizing oscilloscope to terminate data acquisition only when there is a high probability that usable samples have reached the system. Thus, the time interpolator and microprocessor are not forced to incur overhead time to process most of the unusable trigger, thereby resulting in increased throughput for the system. Trigger qualifier circuit 260 provided in accordance with this invention therefore solves a long-felt need in the art for circuitry which significantly increases the throughput of digitizing oscilloscopes using random repetitive data acquisition and signal sampling.

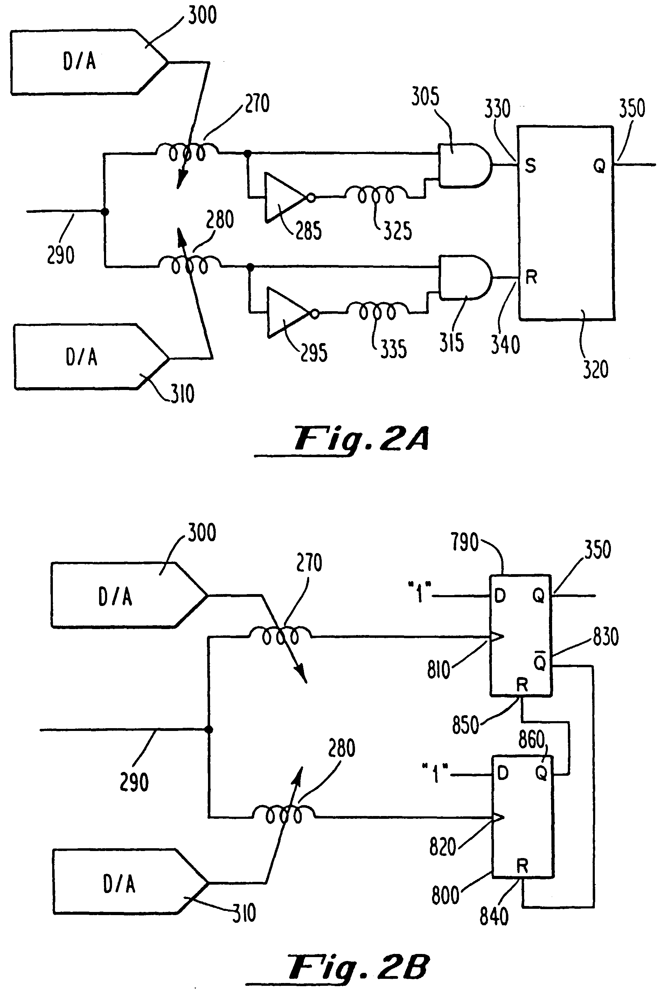

Referring to Figure 2A a preferred embodiment of a trigger qualifier circuit 260 that increases the throughput in a random repetitive data acquisition system is shown. Variable delays 270 and 280 are fed by the sample clock output 290 from the crystal timebase 155. Digital to analog converter (DAC) 300 controls the variation to first variable delay 270 while DAC 310 controls the variation to second variable delay 280. The output of variable delays 270 and 280 are inverted at 285 and 295 then "ANDed" at 305 and 315 respectively with the inverted outputs from inverters 285 and 295. The delays 325 and 335 through AND gates 305 and 315 respectively determine the set and reset pulse widths at 330 and 340.

The output of AND gates 305 and 315 are operatively connected to a logic element 320. In preferred embodiments, logic element 320 is a flip-flop and in further preferred embodiments, a set/reset flip-flop. The output of AND gate 305 sets the flip-flop at 330 while the output of AND gate 315 resets or clears the flip-flop at 340. The output 350 of flip-flop 320 is the qualification signal which arms the qualified trigger circuit 100 periodically.

In preferred embodiments, delays 270 and 280 are variable for at least the sample period, and thus any size window from the minimum that the flip-flop can produce up to the sample period width, with any position relative to the sample clock, can be produced. The CPU calculates the appropriate delay values for any combination of timebase settings which may be determined either by the CPU with appropriate programming, or directly by the user. In further preferred embodiments, the delays may be altered by the user though DACs 300 and 310. The circuit arms the trigger signal in a window having a variable width, accepting triggers that fall within the window and rejecting triggers that fall outside of the window.

In Figure 2B, yet another preferred embodiment of a circuit which qualifies a trigger and increases the throughput in a random repetitive data acquisition system is shown. Replacing the logic element 320, and associated elements 285, 295, 305, 315, 320, 325 and 335 in Figure 2A are a pair of "D" flip-flops shown at 790 and 800. In this configuration, the D inputs to the two flip-flops 790 and 800 are kept at logic "1" (high). The output of variable delay 270 is input to the clock port 810 of D flip-flop 790 while the outputs of variable delay 280 is input to the clock port 820 of D flip-flop 800. The "not Q" output 830 of D flip-flop 790 is coupled to the "reset port" 840 of D flip-flop 800. Furthermore, the reset port 850 of D flip-flop 790 is coupled to the "Q" port 860 of D flip-flop 800. In this configuration, the "Q" output of D flip-flop 790 is the qualification signal 350 which arms the trigger circuit 100 periodically.

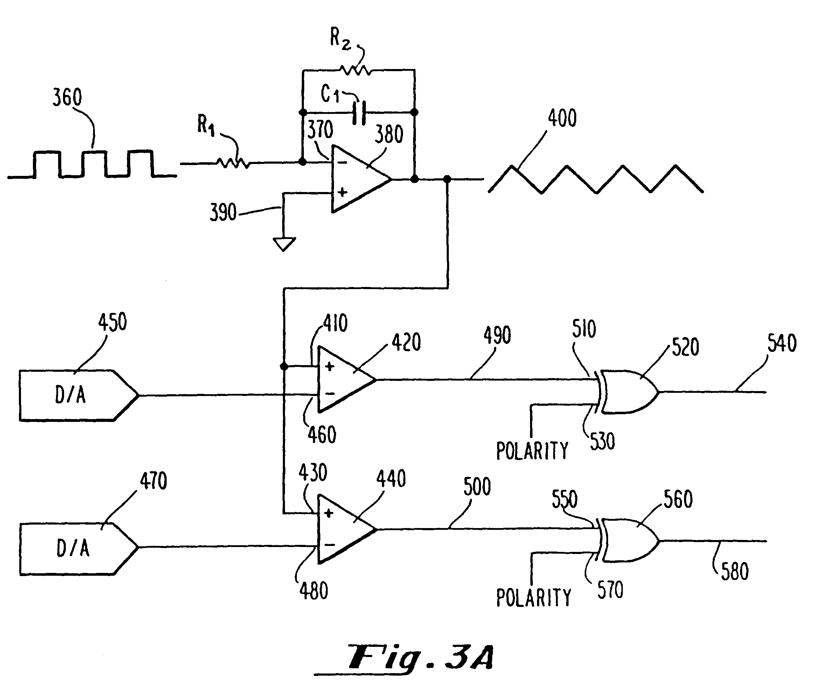

In still further preferred embodiments, variable delays 270 and 280 can be generated by the circuit of Figure 3A. A square waveform 360 from the sample clock is input to the negative port 370 of operational amplifier 380. Operational amplifier 380 is configured in an integrator mode wherein variable resistors $R_1$, $R_2$, and capacitor $C_1$ have values that are chosen for the particular application desired. The positive lead of operational amplifier 380 is grounded at 390. In the integrating mode, operational amplifier 380 turns square waveform 360 in-

to some other continuously varying signal. In preferred embodiments, operational amplifier 380 outputs a triangle wave 400.

Triangle wave 400 is input to the positive input 410 of comparator circuit 420. Triangle wave 400 is also input to the positive input 430 of comparator circuit 440. The output of DAC 450 is input to the negative input 460 of comparator 420. The output of DAC 470 is input to the negative input 480 of comparator 440. In this configuration, comparator circuits 420 and 440 output signals 490 and 500 whenever the amplitude of the triangle wave 400 is above the threshold of DACs 450 and 470 respectively.

Signal 490 is input to a first input 510 of an exclusive OR gate 520. The exclusive OR gate 520 has a second input 530 which is adjustable to allow exclusive OR gate 520 to output a signal 540. Additionally, signal 500 is input to the first input 550 of a second exclusive OR gate 560 having a second input 570 which is also variable to produce an output 580. Signals 540 and 580 can be input to the circuits shown in Figure 2A at 305, 285 and 315, 295, or to the circuit of Figure 2B at 810 and 820 to form the qualifying signal. In this fashion, DACs 450 and 470 and signal polarity selections 530 and 570 provide complete control for trigger window positioning.

In preferred embodiments, a phase-locked loop (PLL) may be used to implement the variable delays in a trigger qualifier circuit 260 provided in accordance with this invention. As shown in Figure 3B, an input signal is applied to a "divide by" N element 581 at node 582 to produce an output at node 583. If the input is a 20 MHz squarewave, then the output could be, for example, a 5 MHz signal which also might be a squarewave. The output is applied to the input node 585 of a phase comparator element 584. Phase comparator 584 compares the signal at node 585 with a feedback signal 586. A phase error signal is output by phase comparator 584 at 587. In preferred embodiments, phase comparator 584 is a digital circuit, analog circuit, or combination digital and analog circuit.

The form of the output 587 depends on the particular characteristics of phase comparator 584. Output 587 is input at 589 to a filter element 588. It is preferred that the filter element be an active filter element comprising a high gain op-amp circuit. In preferred embodiments, an offset signal 589A is input to the active filter 588. The output 589B from active filter 588 is input at 589D to a voltage controlled oscillator (VCO) 589C. VCO 589C outputs a signal whose frequency is proportional to the voltage at its input node 589D. In preferred embodiments the form of this output signal is generally a sine wave or a squarewave. Signal 589E is a variably delayed signal which can be used as the variable delay signals 270 or 280 in Figures 2A and 2B. Variable delay signal 589E is also used in a feedback loop by inputting the signal to "divide by" M element 589F at input node 589G. The output 589H of "divide by" M element 589F is input to phase comparator 586.

A feedback loop comprising elements 584, 588, 589C and 589F uses negative feedback to force the frequency of output 589E to be equal to the input frequency multiplied by M divided by N. In preferred embodiments, the PLL locks signals 583 and 586 either 0°, 90° or 180° out of phase. In further preferred embodiments, phase adjustment input 589A may be used to add an offset which is compensated by the feedback loop. The phase between signals 583 and 586 may be adjusted by the PLL until the change in the phase comparator output 587 cancels the offset applied at 589A. Input 589A can thus be used to provide a variable phase control. When the variable phase control 589A is applied to the PLL at a constant frequency, the variable phase control becomes a variable time delay.

In still further preferred embodiments, the sample clock of the random repetitive signal acquisition system is fed to the PLL at 582. When the output 589E of the PLL must be the same frequency as the input 582, it is necessary that M = N. Furthermore, typical phase comparators shown at 584 have a range of phases which depend upon the particular type of circuit used. To maintain the loop in a phase-locked condition, the range of phase adjustment that is allowed at nodes 583 and 586 is necessarily limited. Typical phase comparators allow from 90° to 360° of phase error. However, when noise and jitter are input to the system, these comparators cannot be pushed to their full operating range and still be expected to keep the loop in a locked state.

If M and N are greater than 1, for example, 2 or 4, the amount of phase variation required at nodes 583 and 586 is reduced by 2 or 4 (M). Thus, for a sample input clock running at 20 MHz and M = N = 4, the signals at nodes 583 and 586 are 5 MHz, and a 90° phase shift at 5 MHz translates to a 360° phase adjustment of the 20 MHz signal at output 589E.

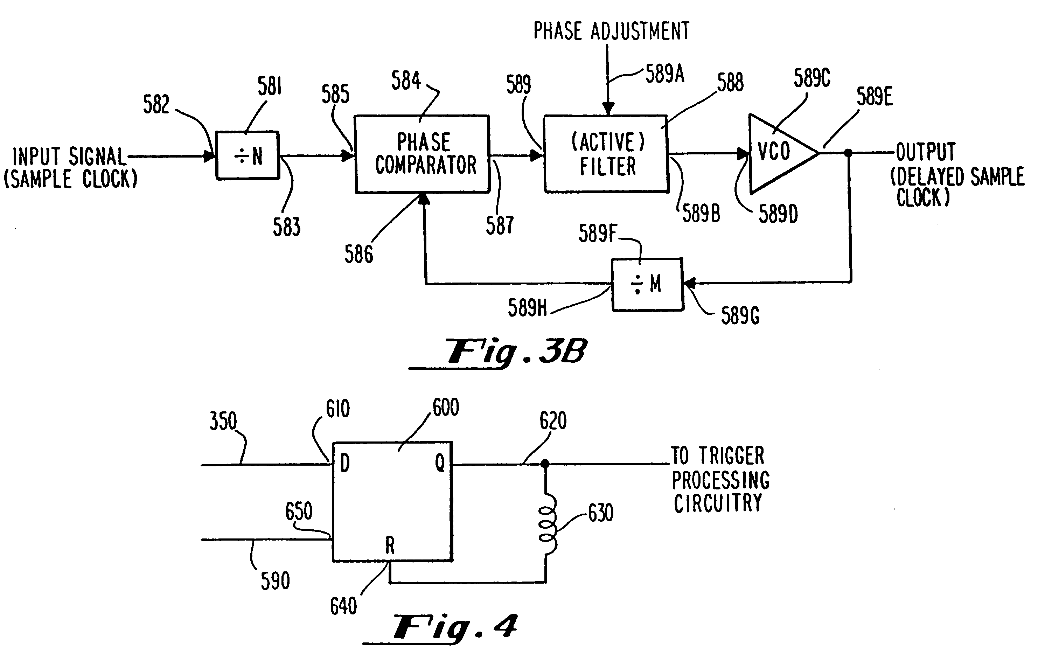

In Figure 4, qualification signal 350 is used to qualify the trigger signal 590. Trigger signal 590 is asynchronous to the sample clock and is input to a flip-flop 600. In preferred embodiments, flip-flop 600 is a D flip-flop. Qualifier signal 350 is input to the D input 610 of D flip-flop 600. Trigger signal 590 is input to the clock input 650 of D flip-flop 600. Output 620 stays low until a trigger occurs while qualification signal 350 is high. Output 620 then goes high. Output 620 is fed back to reset input 640 through delay element 630 to bring output 620 low again. Thus, all trigger events that occur while qualification signal 350 is high result in a qualified trigger output 620, which is then input to the trigger processing circuitry.

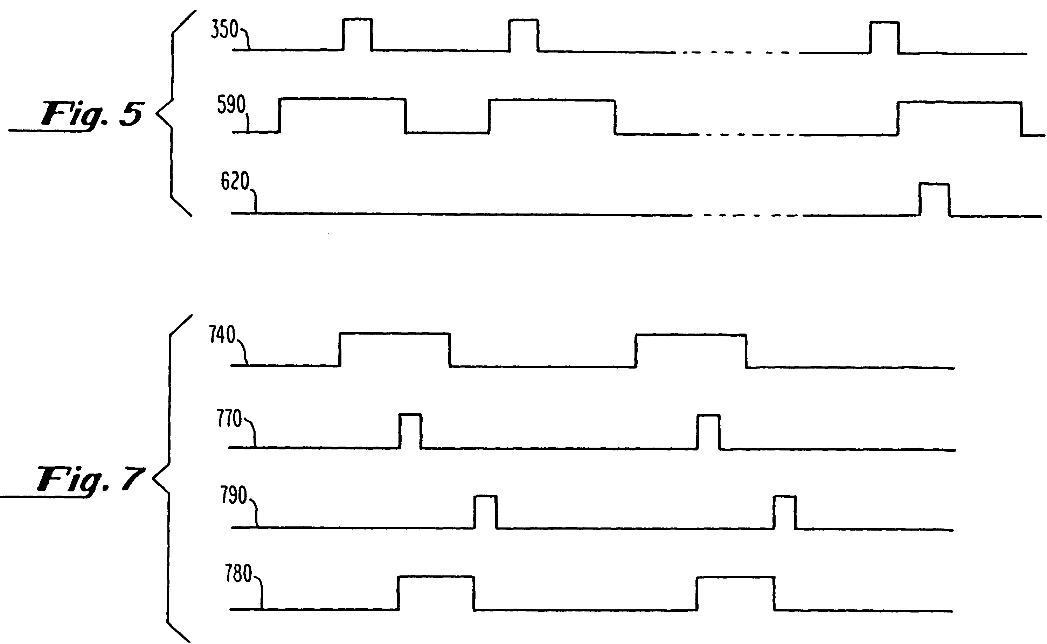

In Figure 5, a timing diagram signifying the various signals appearing in Figure 4 is shown. Signal 350 has a duty cycle which varies directly with the oscilloscope's sweep speed setting. Trigger signal 590 is a standard asynchronous trigger signal found in random repetitive sampling systems. The qualified trigger 620 provided in accordance with this invention terminates data acquisition only when a usable sample is detected. Thus, qualified trigger signal 620 greatly increases the throughput of the system.

For example, if trigger signal 590 is occurring at 15.0 MHz, trigger 590 has a period of 67.0 ns. Further assuming, for example, that the sample rate is 40 MHz, then the time between samples is 25.0 ns. With a screen width of 1.0 ns, the time between samples is 25 times larger than the screen width. Therefore on average, a usable trigger signal 590 is received every 67.0 ns $*$ 25.0 = 1.675 μs. After starting to look for a trigger, the average time to find a usable trigger is 1.675 μs.

Typical random repetitive digitizing oscilloscopes have an acquisition overhead time of about 6.0 μs. With qualified trigger signal 620 provided in accordance with this invention, a usable sample is acquired about every 7.675 μs, i.e. the sum of the average time to find a usable trigger plus the overhead time. Without qualified trigger signals provided in accordance with this invention, it takes the system an average of about 150.8 μs to acquire a usable sample. Therefore, for this exemplary case, the invention increases throughput by a factor determined by dividing 150.8 by 7.675, or about 19.7 times. In general, the longer the overhead time and the faster the trigger repetition rate, the closer the improvement is to the maximum possible, or 25 in this example. Thus, circuitry provided in accordance with this invention solves a long felt need in the art for qualified trigger signals which dramatically increase the throughput in systems which utilize random repetitive signal acquisition.

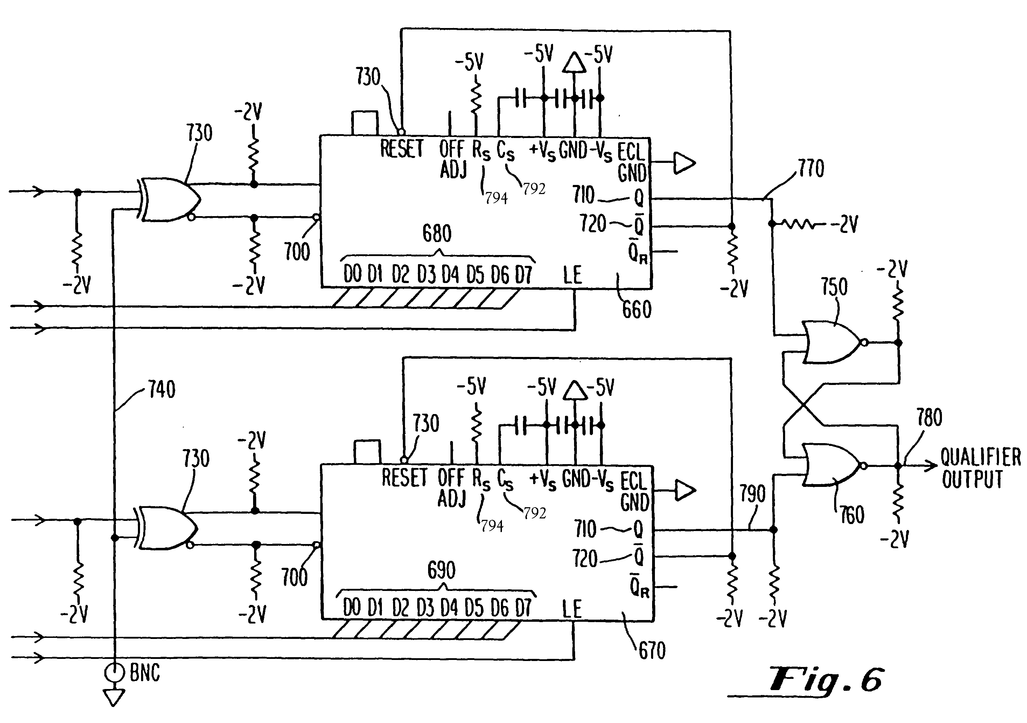

In preferred embodiments, the trigger qualifier signal may be obtained with the circuit shown in Figure 6. Signal 780 is analagous to signal 350 in Figures 2A and 2B. The variable delays are accomplished with a pair of integrated circuits 660 and 670. In further preferred embodiments, integrated circuits 660 and 670 are linear integrated circuits. An excellent linear integrated circuit which can be used to provide programmed delays is the AD9500 Digitally Programmable Delay Generator manufactured and sold by the Analog Devices Company. The AD9500 selects program delays through an 8-bit digital code with resolutions as small as 10 psec.

Microprocessor 210 programs the AD9500 integrated circuits 660 and 670 with a byte of data, i.e., 8 individual bits shown at 680 and 690 on integrated circuits 660 and 670 respectively. The 8 bits of data provide a total possible 256 programmed delays. Each AD9500 has a trigger input shown at 700. When the trigger input goes high, the delay is started.

The delay is generally the sum of the minimum delay through the the AD9500 and the program delay provided by the 8 bits of data 680 and 690. After the delay, the Q output 710 goes high and the not Q output 720 goes low. The device, 660 or 670, is then immediately reset at 730 so that Q 710 resets a delay after it goes high. The end result is a narrow pulse output at Q 710 occurring with a programmable delay from the trigger input.

Exclusive OR gates 730 coupled to the trigger inputs 700 allow microprocessor 210 to select which edge of the input sample clock will trigger each AD9500. Exclusive OR gates 730 selectively invert the clock signal coming in over line 740. Clock signal 740 causes the AD9500s to trigger. The AD9500 at 660 creates a "start" pulse while the AD9500 at 670 creates a "stop" pulse. NOR gates 750 and 760 coupled to the Q outputs of each AD9500 form a flip-flop. The start pulse 770 sets the qualifier output 780 high, while the stop pulse 790 sets the qualifier output 780 low. In preferred embodiments, if both pulses are active at the same time, stop pulse 790 has priority.

This arrangement produces a very narrow pulse on the output of OR gate 760 by causing start pulse 770 to occur just before stop pulse 790. The short output pulse is determined by the difference in delays, not by the actual pulse widths. However, the minimum low time is determined by the pulse widths.

The AD9500s in the circuit of Figure 6 allow for delays in pulse widths in minimum steps of approximately 200 psec with 360° delay coverage and pulse widths from zero to greater than 50 ns. The programmed delays are, in part, also determined by capacitors and resistors shown at 792 and 794 respectively. The use of exclusive OR gates 730 are necessary because of the non-zero delay in resetting the AD9500s and the non-zero minimum delay.

If a rising edge of the sample clock 740 is used to trigger the AD9500s, and if the delay must be programmed to provide a start (stop) pulse "close to" the rising edge of the sample clock, then the delay must be programmed to provide a delay of one sample clock period, since the minimum delay is too long for the start (stop) pulse to be close to the rising edge. Furthermore, the start (stop) pulse delay cannot be negative if it is desired to place the rising edge just before the sample clock rising edge. The start (stop) pulse will then occur just at the next rising edge of the sample clock. This next edge cannot retrigger the AD9500 since it has not yet finished its delay-reset cycle. The AD9500 cannot retrigger until the second sample clock edge following the sample clock edge that caused the initial trigger occurs. Thus, the qualifier signal may only occur once for every two sample clock periods and the throughput has been reduced by a factor of 2 from the theoretical "best."

With the EXOR gates 730 in place, the AD9500 may be triggered on the falling edge of the sample clock. the programmed delay provides a start (stop) pulse on the rising edge of the sample clock and the AD9500 is reset and ready to be triggered again on the next falling edge of the sample clock. The two EXOR gates 730 can be programmed independently to provide the optimum trigger signal (rising or falling edge of the sample clock) to each AD9500 for its required delay.

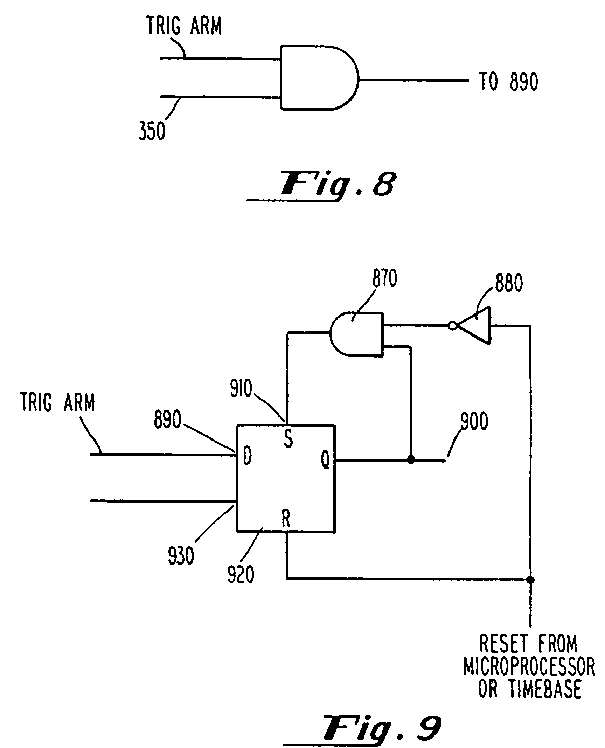

In Figure 7, the timing diagram for the circuit of Figure 6 is shown with the sample clock pulse at 740. Start pulse 770 enables the qualifier signal 780 while stop pulse 790 disables qualifier pulse 780. Qualifier pulse 780 is sensitive to high levels on start pulse 770 and stop pulse 790. The circuit exemplified in Figure 4 may be used in preferred embodiments to provide complete implementation of the qualified trigger by inserting it in the trigger path just before a trigger flip-flop such as, for example, the trigger flip-flop of Figure 9.

However, since a logic element is used in the trigger path, the circuit of Figure 4 introduces a significant amount of jitter to a random repetitive acquisition system. In further preferred embodiments, trigger qualifier signal 350 may be "ANDed" with an existing trigger arming signal as shown in Figure 8 to form a qualified trigger arm signal. As shown in Figure 9, the qualified trigger arm is applied to input 890 of D flip-flop 920 which outputs a qualified trigger signal at 900. Triggered signal 900 is ANDed at 870 with inverted reset signal 880 and input to the set input 910 of D flip-flop 920. The trigger signal is input to flip-flop 920 at clock input 930.

In preferred embodiments, either the user or the microprocessor can determine the delay settings. In order to determine the delays, it must be first recognized that the analog delays from the instrument input to the trigger circuit, and from the instrument input to the sampler are not usually identical. Let the difference in these two delays paths be denoted as $t_{(t-s)}$. If $t_{(t-s)}$ is a positive number, then the delay through the trigger path is longer than the delay through the sampler path. Thus for example, a sample taken $t_{(t-s)}$ before the trigger is received results in that sampling lying on the triggering event. In preferred embodiments, a digitizing oscilloscope comprises a CRT screen wherein data traces are displayed.

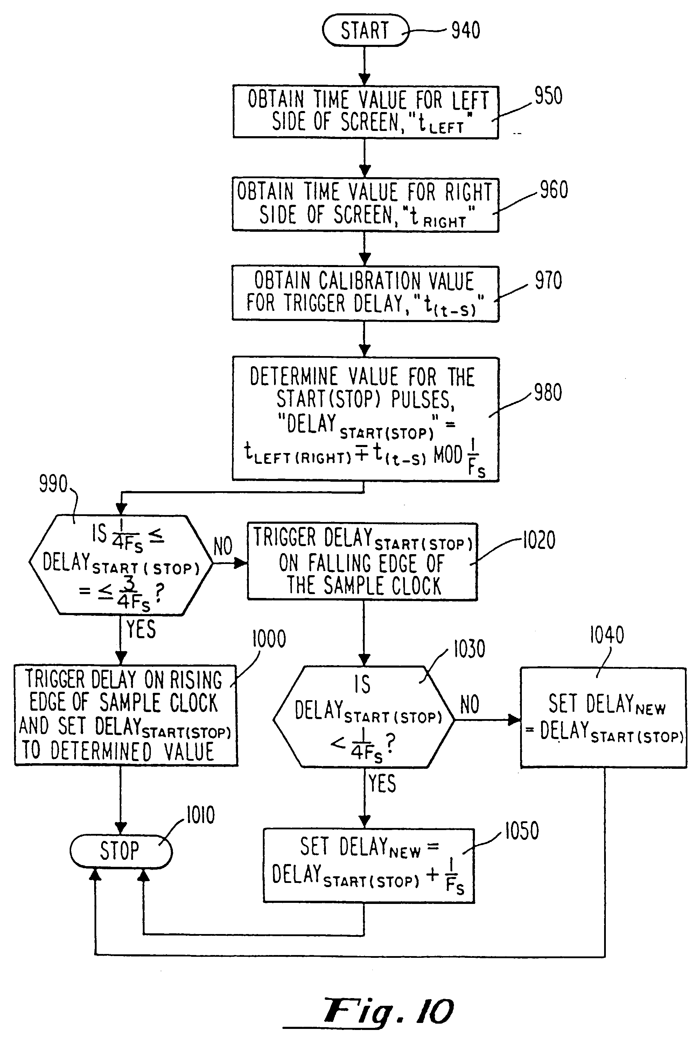

Figure 10 illustrates a programming process which makes use of $t_{(t-s)}$ beginning at step 940. It is desired to find the time value of the left side of the screen with respect to the trigger point. This time value is denoted at step 950 as $t_{left}$ and may be set by the user in preferred embodiments. Similarly, the time value for the right side of the screen with respect to the trigger point, $t_{right}$, is specified at 960.

To find the delay value for the start and stop pulses, herein denoted "start(stop)", it is first necessary to specify the calibration value $t_{(t-s)}$ at step 970, which in further preferred embodiments is defined as a calibration value associated with the trigger delays in the system. At step 980, the delay values "delay$_{start}$" and "delay$_{stop}$" can be obtained respectively by the following equations:

$$delay_{start} = (t_{left} - t_{(t-s)}) \; MOD \; \frac{1}{F_s},$$

$$delay_{stop} = (t_{right} + t_{(t-s)}) \; MOD \; \frac{1}{F_s}.$$

As known by those with skill in the art, $(t_{left} - t_{(t-s)})$

MOD $\frac{1}{F_s}$ is a mathematical operation accomplished by finding the remainder of dividing $(t_{left} + t_{t-s})$ by $1/F_s$. If this remainder is greater than zero, than delay$_{(start)}$ is set to this value. Otherwise, $\frac{1}{F_s}$ is added to this remainder to form a new value, and delay$_{start}$ is set to this new value.

It is then desired to analyze the delay start(stop) times to determine where to trigger the delay with respect to the sample clock signal. This is accomplished at step 990 for the two pulses, delay$_{start(stop)}$, by determining whether:

$$\frac{1}{4F_s} \le delay_{start(stop)} \le \frac{3}{4F_s} \ .$$

If the two delay values fall within this range, then the delays are triggered at step 1000 on the rising edge of the sample clock, and the delay$_{start(stop)}$ values are set to the values determined at step 980 respectively. The programming process is then stopped at step 1010.

However, if the delay$_{start(stop)}$ values are not within the range specified at step 990, it is desired at step 1020 to trigger the delay$_{start(stop)}$ pulses on the falling edge of the sample clock. Preferably, it is determined at step 1030 whether the delay$_{star(stop)}$ value is $< \frac{1}{4F_s}$. If delay$_{start(stop)}$ is not less than $\frac{1}{4F_s}$, then the delay value, now denoted as delay$_{new}$, is set equal to delay$_{start(stop)}$ at step 1040. However, if it is determined that delay$_{start(stop)}$ is less than $\frac{1}{4F_s}$, then delay$_{new}$ is set equal to delay$_{start(stop)} + \frac{1}{F_s}$ at step 1050. The system is then said to be calibrated to the trigger delays, and the programming procedure ends at step 1010. In preferred embodiments, the delay limits are optimal with a 50% duty cycle of the sample pulse. It is expected that other duty cycles will lead to similar optimal values.

As an example of this programming procedure, consider a window having a sweep speed of 100 psec/div with the trigger point being 100 psec to the right of the left edge of the screen, and the sample rate, $F_s$, equal to 40 MHz. Thus, $t_{left}$ equals -100 psec, and $t_{right}$ equals 900 psec. If in preferred embodiments $t_{(t-s)}$ equals -230 psec, then delay$_{start}$ is 24,670 psec, and delay$_{stop}$ equals 670 psec. Since $\frac{1}{4F_s}$ equals 6250 psec, and $\frac{3}{4F_s}$ equals 18,750 psec, it is necessary to trigger the delays on the falling edge of the sample clock. Furthermore, since delay$_{stop}$ = 670 psec is less than $\frac{1}{4F_s}$, delay$_{stop}$ is programmed to 670 psec + 25 nsec = 25,670 psec.

In further preferred embodiments, the digitizing oscilloscope's microprocessor can perform these calculations. However, it will be recognized by those with skill in the art that the user can also perform the programming procedure and calculations.

Trigger qualifier circuitry 260 provided in accordance with this invention also requires conversion of the delay$_{start(stop)}$ qualifier values to binary values which can be used by the delay generator. The time interpolator determines the timing between the asynchronous trigger event and the next sample point within a design resolution, for example, 10 psec. This can be viewed as a calibration which relates the start and stop delay DAC values for the DACs of Figures 2A and 2B to start and stop time interpolator values which can be used by the microprocessor and time interpolator in the crystal timebase 155.

With a random repetitive signal acquisition system having a 1 nsec screen width and 100 psec of pretrigger time, the microprocessor must either be informed of, or determine, the stop and start time values to send to the delay DACs in Figures 2A and 2B. The relationship between the actual binary DAC values and time delays may be assumed to be linear. However, if the relationships are not adequately linear, they may be piece-wise linearly approximated, or approximated by a polynomial expression. When the calibration relationships are linear, the calibration procedure comprises finding "gain" and "offset" values for the start and stop time interpolator values over the range of operation of the time interpolator in the random repetitive signal acquisition system. In further preferred embodiments when the AD9500 integrated circuits are used to provide programmed delays, one gain value for each AD9500 and one offset value for each trigger source (positive or negative edge triggered) for each of the AD9500s, or a total of six calibration values must be obtained.

There are a number of methods which could be used to perform the calibration delay time conversion to start/stop binary DAC values. In preferred embodiments, the designer could calculate the gain and offset values from the actual circuit components including component tolerances. No software is needed for calibration with this method and no user time is needed to periodically calibrate the circuit. However, with this method the window width must typically be larger than required in order to guarantee that worst-case components will still give an adequate window size. This is inefficient since the typical window is bigger than required and therefore accepts a larger percentage of triggers which do not result in useful samples. Use of high precision components will generally result in a more expensive circuit, and thus this design method is generally undesirable.

In still further preferred embodiments, a means to inject the start and stop signals or the trigger qualifier signal into the trigger path may be provided so that calibration is accomplished by disabling the trigger qualifier and feeding the start(stop) signal or trigger qualifier signal to the trigger circuit. The time interpolator may then measure the time between the signal's edge and the sample clock. One measurement would be required for each gain or offset value, and a single measurement could consist of a large number of individual measurements averaged together for accuracy. A circuit of this type to accomplish calibration is not actually part of the operational configuration of the oscilloscope, and so the designer would then have to determine how to modify the calibration (offset) values by relating the delays through the calibration path to the delays through the operational path. This method is relatively fast but since component tolerances are used to relate the operational path and the calibration path, the window width is generally larger than is actually needed to accommodate any possible collection of parts in the instrument. Furthermore, inherent component tolerances reduce the efficiency of the circuit.

Another method to calibrate the delay times to start/stop DAC values is to use a software or firmware program at run time which can determine how to modify the start and stop pulses and optimize the allowed trigger window. With this method, a histogram of time interpolator values is built using random external triggers that occur at run time. The microprocessor can compare a histogram of time interpolator values to a desired histogram and then dynamically adjust the qualifier window. This is an extremely accurate method of calibration since it is essentially a feedback circuit with a large loop gain. However, this method requires a large amount of microprocessor power during run time and therefore decreases the throughput of the random repetitive signal acquisition system.

In still further preferred embodiments, a histogram of time interpolator values may be used to statistically determine the calibration parameters. With this method of calibration, the start and stop control DACs are set to predetermined values and may be further positive/negative sample clock edge triggered if applicable. A large number of random triggers with respect to the sample clock are then generated either by external circuitry, or by the microprocessor. A histogram of time interpolator values is maintained for a statistically significant number of samples, depending upon the resolution of the time interpolator and delay generators. The histogram is then analyzed to determine the exact position of the trigger window. This procedure can then be repeated with new DAC settings and the results can be combined to find the gain and offset values. If applicable, another set of measurements is required with the opposite sample clock edge trigger selected.

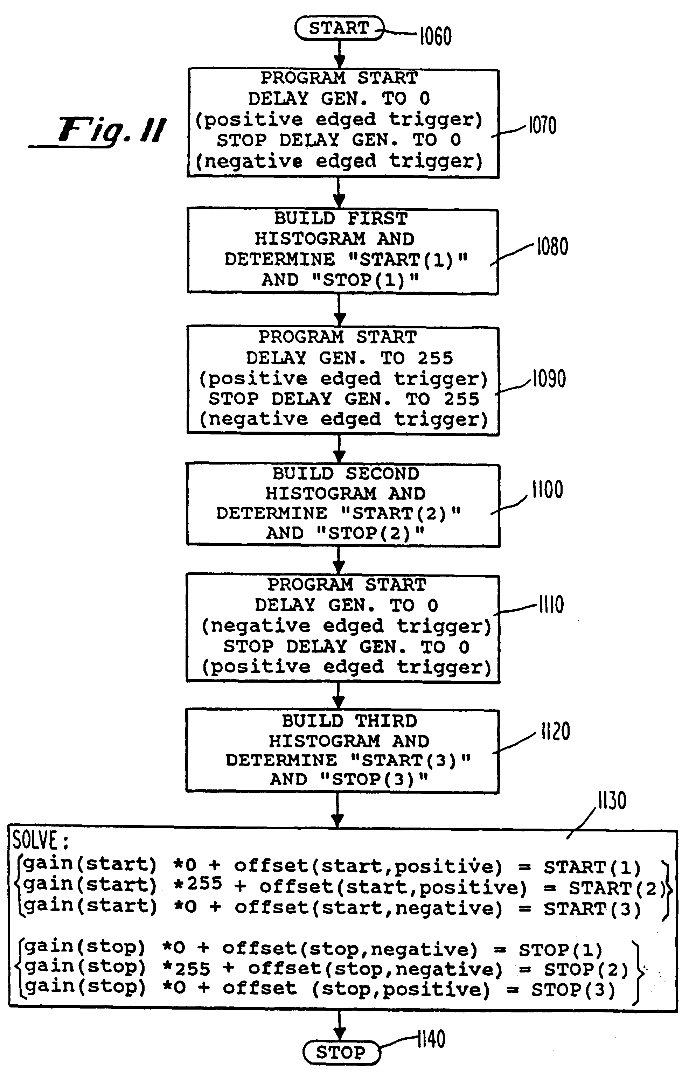

In yet further preferred embodiments, the histogram calibration method can be used with the AD9500 integrated circuit which provides programmed delays for the qualifier circuit. Figure 11 illustrates a method of building a histogram in accordance with the invention. The method begins at step 1060. At step 1070 it is desired to program the start delay generator to zero to be triggered on the positive edge of the sample clock, and the stop delay generator to zero to be triggered on the negative edge of the sample clock. At step 1080, a histogram is built with a statistically significant number of samples, and the first start time "start(1)" and first stop time "stop(1)" are determined from the histogram.

At step 1090 it is then desired to set the start delay generator to some predetermined value to be positively edge triggered, and the stop delay generator to the same predetermined value to be negative edge triggered. In preferred embodiments when the AD9500s are used which have an 8-bit per programmed input, a possible 256 different programmed delays are possible, and therefore, the predetermined value is set to 255. At step 1100, a second histogram is constructed and start(2) and stop(2) are determined.

Similarly, at step 1110, the start delay generator set to zero and is negative edge triggered, while the stop delay generator is set to zero and is positive edge triggered. At step 1120 a third histogram is built and start(3) and stop(3) are determined.

After the first, second, and third start and stop time values are determined, it is necessary to solve the following linear equations which relate the delay values to the time interpolator DAC values:

$$\text{gain(start)} * O + \text{offset(start,positive)} = \text{start(1)}$$

$$\text{gain(start)} * PV + \text{offset(start,positive)} = \text{start(2)}$$

$$\text{gain(start)} * O + \text{offset(start,negative)} = \text{start(3)}$$

$$\text{gain(stop)} * O + \text{offset(stop,negative)} = \text{stop(1)}$$

$$\text{gain(stop)} * PV + \text{offset(stop,negative)} = \text{stop(2)}$$

$$\text{gain(stop)} * O + \text{offset (stop,positive)} = \text{stop(3)};$$

where,

offset(start,positive) = a time offset associated with the first and second start times when the first delay is triggered on the positive edge of the sample signal,
offset(start,negative) = a time offset associated with the third start time when the first delay is triggered on the negative edge of the sample signal,
offset(stop,negative) = a time offset associated with the first and second stop times when the second delay is triggered on the negative edge of the sample signal,

offset(stop,positive) = a time offset associated with the third stop time when the second delay is triggered on the positive edge of the sample signal,

gain(start) = the gain of the start delay generator, in time per program count,

gain(stop) = the gain of the stop delay generator, in time per program count,

PV = the predetermined value.

The above six equations have six unknowns and relate the positive and negative edge triggered offsets and the gains to the start and stop DAC values determined from the histograms. In preferred embodiments, it is desirable to use a low DAC value, i.e., zero, to find the offset and a high DAC value, i.e., 255, to find the gains. This minimizes the errors in finding these values. The equations yield the following solutions:

$$\text{offset(start,positive)} = \text{start(1)}$$

$$\text{gain(start)} = [\text{start(2)} - \text{start(1)}]/PV$$

$$\text{offset(start,negative)} = \text{start(3)}$$

$$\text{offset(stop,positive)} = \text{stop(1)}$$

$$\text{gain(stop)} = [\text{stop(2)} - \text{stop(1)}]/PV$$

$$\text{offset(stop,negative)} = \text{stop(3)}.$$

At run time, these calibration values may be used in a linear equation to turn the desired start(stop) delay time into a binary value to program the start(stop) delay generator. In preferred embodiments, the linear equation is:

$$\text{delay time}_{\text{start(stop)}} = \text{offset (start/stop) \{slope\}} +$$

$$\text{gain}_{\text{start/stop}} * PV,$$

where the "slope" is a function of the particular delay generators used. In general, PV may be other than 0 and 255 when other than an AD9500 is used, and therefore the above equation can be solved for PV. Since PV is an integer value it should be appropriately rounded.

It is also desirable to keep the trigger qualifier window small to minimize the number of iterations the time interpolator must run to build the histograms. For example, assume that one million random triggers are used to build each histogram. With the above programming procedure, then each trigger qualifier window is approximately half the size of the sample period so half of the random triggers would cause the time interpolator to run. Thus, the time interpolator would run an average 500,000 times at 6 μsec each for a total time of 3 seconds to build each histogram. If the procedure is modified so that only a "start(n)" or "stop(n)" value is found with each histogram, then the second (stop or start) delay can be programmed to give a small trigger window.

For example, if the second delay is programmed to give a trigger qualifier window that is only one fiftieth of the sample period, then the time interpolator will only have to run 20,000 times, on average, to build a histogram. Since two histograms must be build to find both start(n) and stop (n), the total calibration time is $2*20,000 * 6\,\mu\text{sec} = 240$ msec. Then, high accuracy can be achieved with a relatively short calibration time by calibrating the start DAC using the stop DAC to provide a small trigger qualifier window, and then calibrating the stop DAC by using the start DAC to provide a small trigger qualifier window.

This method has the advantage of being extremely accurate at the calibration temperature of the system. However, after accounting for component drift with temperature, it may be only slightly better than both the design and trigger disabling methods discussed above. Furthermore, calibration drift as the temperature of the digitizing oscilloscope changes forces recalibration of the time interpolator when the digitizing oscilloscope is being used. This method is also relatively time consuming, taking an average of about one-half second to three seconds to build each histogram, with attendant time added in analyzing each histogram to find the particular start and stop DAC values.

When examining the histogram, the time interpolator outputs values over its defined range within a predetermined resolution. For example, the time interpolator may output values from 0 ns to 50 ns with a one psec resolution. In the absence of noise, the histogram would have a rectangular shape with the edges of the rectangle defining the start and stop times of the qualifier pulse. When noise is added it becomes a statistical task to determine how many samples are necessary to build the histogram and to determine the actual placement of the edges of the pulse for the required accuracy. Analysis of histograms provides an accurate and relatively efficient method of converting the delay values to start and stop DAC values which are useful to the microprocessor to determine what values to program the start and stop DACs to for a particular instrument set-up.

There have thus been described certain preferred embodiments of trigger qualifying methods and apparatus for use in random repetitive signal acquisition systems. While preferred embodiments have been described and disclosed, it will be recognized by those with skill in the art that modifications are within the scope of the invention. The appended claims are intended to cover all such modifications.

## Claims

1. A random repetitive digital signal acquisition system for acquiring and analyzing samples of an input waveform, comprising:

a sample clock (155) for providing a clock signal at a sample clock rate;

sampling means (135, 145) responsive to said sample clock (155) for sampling the input waveform at said sample clock rate so as to acquire a series of samples as a function of time;

triggering means (100) for providing trigger signals relating said series of samples to a known trigger event for display;

trigger qualifier means (260) responsive to said sample clock (155) for creating a trigger qualifying time window with respect to each of said trigger signals within each period of said clock signal;

data acquisition control means (250) responsive to said trigger qualifier means (260) for stopping data acquisition by said sampling means (135, 145) in response to trigger signals from said triggering means (100) during said trigger qualifying time window when there is a high probability that usable samples have been acquired;

means (210) for analyzing said series of samples from said sampling means (135, 145), said series of samples including only those samples acquired for trigger signals which occurred during said trigger qualifying time window; and

means (230) for displaying the analyzed samples.

2. A digital system as in claim 1, wherein said trigger qualifier means (260) comprises a first variable delay circuit (270) for delaying said sample clock (155) by a first delay time and a second variable delay circuit (280) for delaying said sample clock (155) by a second delay time, the beginning and end of said trigger qualifying time window determining said second and first delay times, respectively.

3. A digital system as in claim 2, wherein said trigger qualifier means (260) further comprises means (320; 790) responsive to said sample clock (155) with said first delay time for starting the provision of said trigger signals to said data acquisition control means and means (320; 800) responsive to said sample clock (155) with said second delay time for stopping the provision of said trigger signals to said data acquisition control means (250).

4. A digital system as in claim 3, wherein said starting and stopping means comprises a set/reset flip-flop (320) which receives said sample clock (155) with said first delay time at a set input (330) thereof and said sample clock (155) with said second delay time at a reset input (340) thereof.

5. A digital system as in claim 3, wherein said starting and stopping means comprises first and second D-type flip-flops (790, 800) with high logic levels at D inputs thereof, an inverted output (830) of said first D-type flip-flop (790) being connected to a reset input (840) of said second D-type flip-flop (800) and a non-inverted output (860) of said second D-type flip-flop (800) being connected to a reset input (850) of said first D-type flip-flop (790), said first D-type flip-flop (790) having said sample clock (155) with said first delay time at a clock input (810) thereof and said second D-type flip-flop (800) having said sample clock (155) with said second delay time at a clock input (820) thereof, whereby a non-inverted output of said first D-type flip-flop (790) starts and stops the provision of said trigger signals to said data acquisition control means (250).

6. A digital system as in claim 2, wherein said first and second variable delay circuits (270, 280) comprise an integrating operational amplifier (380) for integrating said sample clock and first and second comparator circuits (420, 440) responsive to said integrating operational amplifier (380) at first inputs (410, 430) thereof and first and second threshold signals at respective second inputs (460, 480) thereof so as to output a sample clock with said first delay time when said first input (410) of said first comparator circuit (420) exceeds said first threshold signal and to output a sample clock with said second delay time when said first input (430) of said second comparator circuit (440) exceeds said second threshold signal.

7. A digital system as in claim 2, wherein said first and second variable delay circuits (270, 280) comprise respective phase locked loops (584-589) which may be phase controlled to respectively output a sample clock with said first or second delay times.

8. A digital system as in claim 2, wherein said first and second variable delay circuits (270, 280) comprise respective programmable delay generators (660, 670).

9. A digital system as in claim 2, wherein the first and second delay times of said first and second variable delay circuits (270, 280) are determined by said analyzing means (210).

10. A digital system as in any preceding claim in the form of a random repetitive sampling oscilloscope, the system further comprising memory means (190, 200) for storing said series of samples.

11. A digital system as in claim 1, wherein a horizontal sweep of said displaying means (230) has a time duration approximately equal to a time duration of said trigger qualifying time window.

12. A random repetitive digital signal acquisition method of acquiring and analyzing samples of an input waveform, comprising the steps of:

sampling the input waveform at a sample clock rate from a sample clock (155) so as to acquire a series of samples as a function of time;
providing trigger signals relating said series of samples to a known trigger event for display;
creating a trigger qualifying time window with respect to each of said trigger signals within each period of a clock signal from said sample clock;
stopping data acquisition in said sampling step in response to trigger signals during said trigger qualifying time window when there is a high probability that usable samples have been acquired;
analyzing said series of samples, said series of samples including only those samples acquired for trigger signals which occurred during said trigger qualifying time window; and
displaying the analyzed samples.

13. A method as in claim 12, wherein said trigger qualifying time window creating step further comprises the steps of delaying said sample clock by a first delay time and delaying said sample clock by a second delay time, the beginning and end of said trigger qualifying time window determining said second and first delay times, respectively.

14. A method as in claim 13, wherein said trigger qualifying time window creating step further comprises the steps of starting the provision of said trigger signals in said trigger signals providing step in response to a sample clock with said first delay time and of stopping the provision of said trigger signals in said trigger signals providing step in response to a sample clock with said second delay time.

15. A method as in claim 13, wherein said delaying steps comprise the steps of integrating said sample clock to produce an integrated output, comparing said integrated output to first and second threshold signals, outputting a sample clock with said first delay time when said integrated output exceeds said first threshold signal and outputting a sample clock with said second delay time when said integrated output exceeds second threshold signal.

16. A method as in claim 13, wherein said delaying steps comprise the steps of:

determining start and stop time values for provision of said trigger signals;
obtaining a calibration value representing the difference in delay between (a) the delay from an input for said input waveform for means for providing said trigger signals and (b) the delays from said input waveform to means for sampling;
obtaining start and stop pulse delay values from said start and stop time values, said calibration value and said sample clock;
analyzing the start and stop pulse delay values to determine where to trigger delays with respect to the sample clock so as to form said trigger qualifying time window; and
determining whether to trigger delays with respect to rising or falling edges of the sample clock.

17. A method as in claim 16, wherein the step of obtaining a calibration value comprises the steps of:

setting the first delay time to zero and triggering the start of the first delay time on a positive edge of the sample clock and setting the second delay time to zero and triggering the start of the second delay time on a negative edge of the sample clock;
building a first histogram from a statistically significant number of said series of samples and determining a first delay start and a first delay stop time from the first histogram;
setting the first delay time to a predetermined upper limit value and triggering the start of the first delay time on a positive edge of the sample clock and setting the second delay time to said predetermined upper limit value and triggering the start of the second delay time on a negative edge of the sample clock;
building a second histogram from said statistically significant number of said series of samples and determining a second delay start and a second delay stop time from the second histogram;
setting the first delay time to zero and triggering the start of the first delay time on a negative edge of the sample clock and setting the second delay time to zero and triggering the start of the second delay time on a positive edge of the sample clock;
building a third histogram from said statistically significant number of said series of samples and determining a third delay start and a third delay stop time from the third histogram; and relating said first, second and third delay start and stop times to positive negative edge triggered offsets and gains of the sample clock.

## Patentansprüche

1. Ein digitales Zufallswiederholungs-Signalerfassungssystem zum Erfassen und Analysieren von Abtastwerten einer Eingangssignalform, mit folgenden Merkmalen:

    einem Abtasttakt (155) zum Liefern eines Taktsignals bei einer Abtasttaktrate;

    einer Abtasteinrichtung (135, 145), die auf den Abtasttakt (155) anspricht, zum Abtasten der Eingangssignalform bei der Abtasttaktrate, um eine Serie von Abtastwerten als Funktion der Zeit zu erfassen;

    einer Triggereinrichtung (100) zum Liefern von Triggersignalen, die die Serie von Abtastwerten auf ein bekanntes Triggerereignis zur Anzeige beziehen;

    einer Triggerqualifiziereinrichtung (260), die auf den Abtasttakt (155) anspricht, zum Erzeugen eines Triggerqualifizierungszeitfensters bezüglich jedes der Triggersignale innerhalb jeder Periode des Abtastsignals;

    einer Datenerfassungssteuerungseinrichtung (250), die auf die Triggerqualifiziereinrichtung (260) anspricht, zum Stoppen der Datenerfassung durch die Abtasteinrichtung (135, 145) als Reaktion auf Triggersignale von der Triggereinrichtung (100) während des Triggerqualifizierungszeitfensters, wenn eine hohe Wahrscheinlichkeit vorhanden ist, daß verwendbare Abtastwerte erfaßt worden sind;

    einer Einrichtung (210) zum Analysieren der Serie von Abtastwerten von der Abtasteinrichtung (135, 145), wobei die Serie von Abtastwerten nur die Abtastwerte umfaßt, die für Triggersignale erfaßt worden sind, welche während des Triggerqualifizierungszeitfensters auftraten; und

    einer Einrichtung (230) zum Anzeigen der analysierten Abtastwerte.

2. Ein digitales System gemäß Anspruch 1, bei dem die Triggerqualifiziereinrichtung (260) eine erste variable Verzögerungsschaltung (270) zum Verzögern des Abtasttakts (155) um eine erste Verzögerungszeit und eine zweite variable Verzögerungsschaltung (280) zum Verzögern des Abtasttakts (155) um eine zweite Verzögerungszeit aufweist, wobei der Beginn und das Ende des Triggerqualifizierungszeitfensters die zweite bzw. die erste Verzögerungszeit bestimmen.

3. Ein digitales System gemäß Anspruch 2, bei dem die Triggerqualifiziereinrichtung (260) ferner eine Einrichtung (320; 790), die auf den Abtasttakt (155) mit der ersten Verzögerungszeit anspricht, um das Liefern der Triggersignale zu der Datenerfassungssteuerungseinrichtung zu starten, und eine Einrichtung (320; 800), die auf den Abtasttakt (155) mit der zweiten Verzögerungszeit anspricht, zum Stoppen des Bereitstellens der Triggersignale zu der Datenerfassungssteuerungseinrichtung (250) aufweist.

4. Ein digitales System gemäß Anspruch 3, bei dem die Start- und Stopp-Einrichtung ein Setzen/Rücksetzen-Flip-Flop (320) aufweisen, welches den Abtasttakt (155) mit der ersten Verzögerungszeit an einem Setzen-Eingang (330) von sich und den Abtasttakt (155) mit der zweiten Zeitverzögerung an einem Rücksetzen-Eingang (340) von sich empfängt.

5. Ein digitales System gemäß Anspruch 3, bei dem die Start- und Stopp-Einrichtung ein erstes und ein zweites D-Typ-Flip-Flop (790, 800) mit hohen logischen Pegeln an D-Eingängen derselben aufweisen, wobei ein invertierter Ausgang (830) des ersten D-Typ-Flip-Flops (790) mit einem Rücksetzen-Eingang (840) des zweiten D-Typ-Flip-Flops (800) verbunden ist, und wobei ein nicht-invertierter Ausgang (860) des zweiten D-Typ-Flip-Flops (800) mit einem Rücksetzen-Eingang (850) des ersten D-Typ-Flip-Flops (790) verbunden ist, wobei das erste D-Typ-Flip-Flop (790) den Abtasttakt (155) mit der ersten Verzögerungszeit an einem Takteingang (810) von sich aufweist, während das zweite D-Typ-Flip-Flop (800) den Abtasttakt (155) mit der zweiten Verzögerungszeit an einem Takteingang (820) von sich aufweist, wodurch ein nicht-invertiertes Ausgangssignal des ersten D-Typ-Flip-Flops (790) das Liefern der Triggersignale zu der Datenerfassungssteuerungseinrichtung (250) startet und stoppt.

6. Ein digitales System gemäß Anspruch 2, bei dem die erste und die zweite variable Verzögerungsschaltung (270, 280) einen integrierenden Operationsverstärker (380) zum Integrieren des Abtasttakts und eine erste und eine zweite Komparatorschaltung (420, 440) aufweisen, die auf den integrierenden Operationsverstärker (380) an ersten Eingängen (410, 430) derselben und auf ein erstes und ein zweites Schwellensignal an jeweiligen zweiten Eingängen (460, 480) derselben ansprechen, um einen Abtasttakt mit der ersten Zeitverzögerungszeit auszugeben, wenn das erste Eingangssignal (410) der ersten Komparatorschaltung (420) das erste Schwellensignal überschreitet, und um einen Abtasttakt mit der zweiten Verzögerungszeit auszugeben, wenn der erste Eingang (430) der zweiten Komparatorschaltung (440) das zweite Schwellensignal überschrietet.

7. Ein digitales System gemäß Anspruch 2, bei dem die erste und die zweite variable Verzögerungsschaltung (270, 280) jeweilige Phasenregelschleifen (584 - 589) aufweisen, welche phasengesteuert sein können, um jeweils einen Abtasttakt mit der ersten oder der zweiten Verzögerungszeit auszugeben.

8. Ein digitales System gemäß Anspruch 2, bei dem die erste und die zweite variable Verzögerungsschaltung (270, 280) jeweilige programmierbare Verzögerungsgeneratoren (660, 670) aufweisen.

9. Ein digitales System gemäß Anspruch 2, bei dem die erste und die zweite Verzögerungszeit der ersten und der zweiten variablen Verzögerungsschaltung (270, 280) durch die Analysiereinrichtung (210) bestimmt werden.

10. Ein digitales System gemäß einem der vorhergehenden Ansprüche in der Form eines Zufallswiederholungs-Abtastoszilloskops, wobei das System ferner eine Speichereinrichtung (190, 200) zum Speichern der Serie von Abtastwerten aufweist.

11. Ein digitales System gemäß Anspruch 1, bei dem eine Horizontalwobbelung der Anzeigeeinrichtung (230) eine Zeitdauer aufweist, die etwa gleich einer Zeitdauer des Triggerqualifizierungszeitfensters ist.

12. Ein Zufallswiederholungs-Digitalsignalerfassungsverfahren zum Erfassen und Analysieren von Abtastwerten einer Eingangssignalform, mit folgenden Schritten:

Abtasten der Eingangssignalform mit einer Abtasttaktrate von einem Abtasttakt (155), um eine Serie von Abtastwerten als Funktion der Zeit zu erfassen;

Liefern von Triggersignalen, die die Serie von Abtastwerten auf ein bekanntes Triggerereignis zur Anzeige beziehen;

Erzeugen eines Triggerqualifizierungszeitfensters bezüglich jedes der Triggersignale innerhalb jeder Periode eines Taktsignals aus dem Abtasttakt;

Stoppen der Datenerfassung in dem Abtastungsschritt als Reaktion auf Triggersignale während des Triggerqualifizierungszeitfensters, wenn eine hohe Wahrscheinlichkeit vorhanden ist, daß verwendbare Abtastwerte erfaßt worden sind;

Analysieren der Serie von Abtastwerten, wobei die Serie von Abtastwerten nur die Abtastwerte umfaßt, die für Triggersignale erfaßt wurden, welche während des Triggerqualifizierungszeitfensters auftraten; und

Anzeigen der analysierten Abtastwerte.

13. Ein Verfahren gemäß Anspruch 12, bei dem der Schritt des Erzeugens des Triggerqualifizierungszeitfensters ferner die Schritte des Verzögerns des Abtasttakts um eine erste Verzögerungszeit und des Verzögerns des Abtasttakts um eine zweite Verzögerungszeit aufweist, wobei der Beginn und das Ende des Triggerqualifizierungszeitfensters die zweite bzw. die erste Verzögerungszeit bestimmen.

14. Ein Verfahren gemäß Anspruch 13, bei dem der Schritt des Erzeugens des Triggerqualifizierungszeitfensters ferner die Schritte des Startens des Lieferns der Triggersignale in dem Schritt des Lieferns der Triggersignale als Reaktion auf einen Abtasttakt mit der ersten Zeitverzögerung und des Anhaltens des Bereitstellens der Triggersignale in dem Schritt des Bereitstellens der Triggersignale als Reaktion auf einen Abtasttakt mit der zweiten Verzögerungszeit aufweist.

15. Ein Verfahren gemäß Anspruch 13, bei dem die Schritte Verzögerns die Schritte des Integrierens des Abtasttakts, um ein integriertes Ausgangssignal zu erzeugen, des Vergleichens des integrierten Ausgangssignals mit einem ersten und mit einem zweiten Schwellensignal, des Ausgebens eines Abtasttakts mit der ersten Verzögerungszeit, wenn das integrierte Ausgangssignal das erste Schwellensignal überschreitet, und des Ausgebens eines Abtasttakts mit der zweiten Verzögerungszeit aufweisen, wenn das integrierte Ausgangssignal das zweite Schwellensignal überschreitet.

16. Ein Verfahren gemäß Anspruch 13, bei dem die Verzögerungsschritte folgende Schritte aufweisen:

Bestimmen eines Start- und eines Stoppzeitwerts zum Liefern der Triggersignale;

Erhalten eines Kalibrationswerts, der die Differenz der Verzögerung zwischen (a) der Verzögerung von einem Eingang für die Eingangssignalform zu einer Einrichtung zum Liefern der Triggersignale und (b) die Verzögerungen von der Eingangssignalform zu einer Einrichtung zum Abtasten darstellt;

Erhalten von Start- und Stoppulsverzögerungswerten von den Start- und dem Stoppzeitwert, dem Kalibrationswert und dem Abtasttakt;

Analysieren der Start- und Stoppulsverzögerungswerte, um zu bestimmen, ob Verzögerungen bezüglich des Abtasttakts zu triggern sind, um das Triggerqualifizierungszeitfenster zu bilden; und

Bestimmen, ob Verzögerungen bezüglich der steigenden oder der fallenden Flanke des Abtasttakts zu triggern sind.

17. Ein Verfahren gemäß Anspruch 16, bei dem der Schritt des Erhaltens eines Kalibrationswerts folgende Schritte aufweist:

Einstellen der ersten Verzögerungszeit auf Null und Triggern des Starts der ersten Verzögerungszeit bei einer positiven Flanke des Abtasttakts und Einstellen der zweiten Verzögerungszeit auf Null und Triggern des Starts der zweiten Verzögerungszeit bei einer negativen Flanke des Abtasttakts;

Bauen eines ersten Histogramms aus einer statistisch signifikanten Anzahl der Serie von Abtastwerten und Bestimmen einer ersten Verzögerungsstart- und einer ersten Verzögerungsstopp-Zeit aus dem ersten Histogramm;

Einstellen der ersten Verzögerungszeit auf einen vorbestimmten oberen Grenzwert und Triggern des Starts der ersten Verzögerungszeit bei einer positiven Flanke des Abtasttakts und Einstellen der zweiten Verzögerungszeit auf einen vorbestimmten oberen Grenzwert und Triggern des Starts der zweiten Verzögerungszeit bei einer negativen Flanke des Abtasttakts;

Bauen eines zweiten Histogramms aus der statistisch signifikanten Anzahl der Serie von Abtastwerten und Bestimmen einer zweiten Verzögerungsstart- und einer zweiten Verzögerungsstopp-Zeit aus dem zweiten Histogramm;

Einstellen der ersten Verzögerungszeit auf Null und Triggern des Starts der ersten Verzögerungszeit bei einer negativen Flanke des Abtasttakts und Einstellen der zweiten Verzögerungszeit auf Null und Triggern des Starts der zweiten Verzögerungszeit auf eine positive Flanke des Abtasttakts;

Bauen eines dritten Histogramms aus der statistisch signifikanten Anzahl der Serie von Abtastwerten und Bestimmen einer dritten Verzögerungsstart- und einer dritten Verzögerungsstopp-Zeit aus dem dritten Histogramm; und

Beziehen der ersten, der zweiten und dritten Verzögerungsstart- und Stopp-Zeit auf auf die positive oder negative Flanke getriggerte Versätze und Verstärkungen des Abtasttakts.

## Revendications

1. Un système d'acquisition de signaux numériques à répétitivité aléatoire destiné à acquérir et à analyser des échantillons d'une forme d'onde d'entrée, comprenant :

un signal d'horloge d'échantillon (154) pour produire un signal d'horloge à une cadence de signaux d'horloge d'échantillon,
un moyen d'échantillonnage (135, 145) qui répond audit signal d'horloge d'échantillon (155) pour échantillonner la forme d'onde d'entrée à ladite cadence de signaux d'horloge d'échantillons de façon à acquérir une série d'échantillons en fonction du temps;
un moyen de déclenchement (100) pour produire des signaux de déclenchement qui relient à un événement connu de déclenchement ladite série d'échantillons pour les afficher;
un moyen de qualification (260) de déclenchement qui répond audit signal d'horloge d'échantillon (155) pour créer une fenêtre de temps de qualification de déclenchement par rapport à chacun desdits signaux de déclenchement à l'intérieur de chaque période dudit signal d'horloge;
un moyen de commande (250) d'acquisition de données qui répond audit moyen de qualification (260) de déclenchement pour arrêter une acquisition de données par ledit moyen d'échantillonnage (135, 145) en réponse à des signaux de déclenchement provenant dudit moyen de déclenchement (100) pendant ladite fenêtre de temps de qualification de déclenchement lorsqu'il existe une probabilité élevée que des échantillons utilisables ont été acquis;
un moyen (210) d'analyse de ladite série d'échantillons provenant dudit moyen d'échantillonnage (135, 145), ladite série d'échantillons n'incluant que les échantillons acquis pour des signaux de déclenchement qui se sont produits pendant ladite fenêtre de temps de qualification de déclenchement; et
un moyen (23) d'affichage des échantillons analysés

2. Un système numérique selon la revendication 1, dans lequel ledit moyen de qualification (260) de déclenchement comprend un premier circuit (270) à retard variable pour retarder d'un premier temps de retard ledit signal d'horloge d'échantillon (155) et un deuxième circuit (280) à retard variable pour retarder d'un deuxième temps de retard ledit signal d'horloge d'échantillon (155), le début et la fin de ladite fenêtre de temps de qualification de déclenchement déterminant lesdits deuxième et premier temps de retard, respectivement.

3. Un système numérique selon la revendication 2 dans lequel ledit moyen de qualification de déclenchement (260) comprend en outre un moyen (320; 790) qui répond audit signal d'horloge d'échantillon (155) affecté dudit premier temps de retard pour débuter l'envoi desdits signaux de déclenchement audit moyen de commande d'acquisition de données et un moyen (320; 800) qui répond audit signal d'horloge d'échantillon (155) affecté dudit deuxième temps de retard pour arrêter l'envoi desdits signaux de déclenchement audit moyen de commande (250) d'acquisition de données.

4. Un système numérique selon la revendication 3, dans lequel ledit moyen de début et d'arrêt comprend une bascule (320) de mise en place/restauration qui reçoit, à son entrée de mise en place (330), ledit signal d'horloge d'échantillon (155) affecté dudit premier temps de retard et, à son entrée de restauration (340), ledit signal d'horloge d'échantillon (155) affecté dudit deuxième temps de retard.

5. Un système numérique selon la revendication 3 dans lequel ledit moyen de début et d'arrêt comprend une première et une deuxième bascules de type D (790, 800) à niveaux logiques hauts à leurs entrées D, une sortie inversée (830) de ladite première bascule de type D (790) étant connectée à une entrée de restauration (840) de ladite deuxième bascule de type D (800) et une entrée sans inversion (860) de ladite deuxième bascule de type D (800) étant connectée à une entrée de restauration (850) de ladite première bascule de type D (790), ladite première bascule de type D (790) recevant ledit signal d'horloge d'échantillon (155) affecté dudit premier temps de retard à une entrée de signal d'horloge (810) de la bascule, et ladite deuxième bascule de type D (800) recevant ledit signal d'horloge d'échantillon (155) affecté dudit deuxième temps de retard à une entrée de signal d'horloge (820) de la bascule, grâce à quoi une sortie sans inversion de ladite première bascule de type D (790) débute et arrête l'envoi desdits signaux de déclenchement audit moyen de commande (250) d'acquisition de données.

6. Un système numérique selon la revendication 2, dans lequel lesdits premier et deuxième circuits (270, 280) à temps de retard variable comprennent un amplificateur opérationnel intégrateur (380) pour intégrer ledit signal d'horloge d'échantillon et un premier et un deuxième circuits comparateurs (420, 440) qui répondent audit amplificateur opérationnel intégrateur (380) à des premières entrées (410, 430) de ces comparateurs et à un premier et un deuxième signaux de seuil à des deuxièmes entrées respectives (460, 480) de ces comparateurs de façon à produire un signal d'horloge d'échantillon affecté dudit premier temps de retard lorsque ladite première entrée (410) dudit premier circuit comparateur (420) dépasse ledit premier signal de seuil et pour produire un signal d'horloge d'échantillon affecté dudit deuxième temps de retard lorsque ladite première entrée (430) dudit deuxième circuit comparateur (440) dépasse ledit deuxième signal de seuil.

7. Un système numérique selon la revendication 2, dans lequel lesdits premier et deuxième circuits (270, 280) à retard variable comprennent des boucles respectives verrouillées en phase (584 à 589) qui peuvent être commandées en phase de façon à produire respectivement un signal d'horloge d'échantillon affecté des premier ou deuxième temps de retard.

8. Un système numérique selon la revendication 2, dans lequel lesdits premier et deuxième circuits (270, 280) à retard variable comprennent des générateurs respectifs (660, 670) à retard programmable.

9. Un système numérique selon la revendication 2, dans lequel le premier et le deuxième temps de retard desdits premier et deuxième circuits (270, 280) à retard variable sont déterminés par ledit moyen d'analyse (210).

10. Un système numérique selon une revendication précédente quelconque en forme d'oscilloscope d'échantillonnage répétitif aléatoire, le système comprenant en outre un moyen de mémoire (190, 200) pour mémoriser ladite série d'échantillons.

11. Un système numérique selon la revendication 1, dans lequel la durée de temps d'un balayage horizontal dudit moyen d'affichage (230) est approximativement égale à une durée de temps de ladite fenêtre de temps de qualification de déclenchement.

12. Un procédé d'acquisition de signaux numériques répétitifs aléatoires, destiné à acquérir et analyser des échantillons d'une forme d'onde d'entrée et comprenant les étapes consistant à :

échantillonner la forme d'entrée à une cadence de signaux d'horloge d'échantillon provenant d'un signal d'horloge d'échantillon (155) de façon à acquérir une série d'échantillons en fonction du temps;

envoyer des signaux de déclenchement qui relient à un événement connu de déclenchement ladite série d'échantillons en vue de les afficher;

créer une fenêtre de temps de qualification de déclenchement par rapport à chacun desdits signaux de déclenchement à l'intérieur de chaque période d'un signal d'horloge provenant dudit signal d'horloge d'échantillon;

arrêter une acquisition de données dans ladite étape d'échantillonnage en réponse à des signaux de déclenchement pendant ladite fenêtre de temps de qualification de déclenchement lorsqu'il existe une probabilité élevée que des échantillons utilisables ont été acquis;

analyser ladite série d'échantillons, ladite série d'échantillons n'incluant que des échantillons acquis pour des signaux de déclenchement qui se sont produits pendant ladite fenêtre de temps de qualification de déclenchement; et

afficher les échantillons analysés.

13. Un procédé selon la revendication 12 dans lequel ladite création de fenêtre de temps de qualification de déclenchement comprend en outre les étapes consistant à retarder d'un premier temps de retard ledit signal d'horloge d'échantillon et à retarder d'un deuxième temps de retard ledit signal d'horloge d'échantillon, le début et la fin de ladite fenêtre de temps de qualification de déclenchement déterminant lesdits deuxième et premier temps de retard, respectivement.

14. Un procédé selon la revendication 13, dans lequel ladite étape de création de la fenêtre de temps de qualification de déclenchement comprend en outre les étapes consistant à débuter l'envoi desdits signaux de déclenchement dans la dite étape d'envoi de signaux de déclenchement en réponse à un signal d'horloge d'échantillon affecté dudit premier temps de retard et à arrêter l'envoi desdits signaux de déclenchement dans la dite étape d'envoi de signaux de déclenchement en réponse à un signal d'horloge d'échantillon affecté dudit deuxième temps de retard.

15. Un procédé selon la revendication 13 dans lequel lesdites étapes de retardement comprennent les étapes consistant à intégrer ledit signal d'horloge d'échantillon pour produire une sortie intégrée, comparer ladite sortie intégrée à un premier et un deuxième signaux de seuil, produire un signal d'horloge d'échantillon affecté dudit premier temps de retard lorsque ladite sortie intégrée dépasse ledit premier signal de seuil et produire un signal d'horloge d'échantillon affecté dudit deuxième temps de retard lorsque ladite sortie intégrée dépasse ledit deuxième signal de seuil.

16. Un procédé selon la revendication 13, dans lequel lesdites étapes de retard comprennent les étapes consistant à :

déterminer des valeurs de temps de début et d'arrêt pour l'envoi desdits signaux de déclenchement;

obtenir une valeur de calibrage qui représente la différence de retard entre (a) le retard provenant d'une entrée pour ladite forme d'onde d'entrée pour un moyen d'envoi desdits signaux de déclenchement et (b) les retards provenant de ladite forme d'onde d'entrée à des moyens d'échantillonnage;

obtenir des valeurs de retard d'impulsions de début et d'arrêt, à partir desdites valeurs de temps de début et d'arrêt, de ladite valeur de calibrage et dudit signal d'horloge;

analyser les valeurs de retard d'impulsions de début et d'arrêt pour déterminer à quel instant déclencher des retards par rapport audit signal d'horloge de façon à former ladite fenêtre de temps de qualification de déclenchement; et

déterminer s'il y a lieu de déclencher des retards par rapport à des bords montants ou descendants dudit signal d'horloge d'échantillon.

17. Un procédé selon la revendication 16, dans lequel ladite étape d'obtention d'une valeur de calibrage comprend les étapes consistant à:

régler à zéro le premier temps de retard et déclencher le début du premier temps de retard sur un bord montant du signal d'horloge d'échantillon et régler à zéro le deuxième temps de retard et déclencher le début du deuxième temps de retard sur un bord négatif du signal d'horloge d'échantillon;

établir un premier histogramme à partir d'un nombre statistiquement significatif de ladite série d'échantillons et déterminer à partir du premier histogramme un premier temps de début de retard et un premier temps d'arrêt de retard;

régler à une valeur limite supérieure prédéterminée le premier temps de retard et déclencher le début du premier temps de retard sur un bord positif du signal d'horloge et régler le deuxième temps de retard à ladite valeur limite supérieure prédéterminée et déclencher le début du deuxième temps de retard sur un bord négatif du signal d'horloge d'échantillon;

établir un deuxième histogramme à partir dudit nombre statistiquement significatif de ladite série d'échantillons et déterminer à partir du deuxième histogramme un deuxième temps de début de retard et un deuxième temps d'arrêt de retard;

régler à zéro le premier temps de retard et déclencher le début du premier temps de retard sur un bord négatif du signal d'horloge d'échantillon et régler à zéro le deuxième temps de retard et déclencher le début du deuxième temps de retard sur un bord positif du signal d'horloge d'échantillon;

établir un troisième histogramme à partir dudit nombre statistiquement significatif de ladite série d'échantillons et déterminer à partir du troisième histogramme un troisième temps de début de retard et un troisième temps d'arrêt de retard; et

relier lesdits premier, deuxième et troisième temps de début et d'arrêt de retard à des déports des gains du signal d'horloge d'échantillon déclenchés par un bord positif ou négatif.

_Fig. 1_

EP 0 444 875 B1

*Fig.2A*

*Fig.2B*

*Fig. 3A*

EP 0 444 875 B1

PHASE ADJUSTMENT

INPUT SIGNAL
(SAMPLE CLOCK) → ÷N → PHASE COMPARATOR → (ACTIVE) FILTER → VCO → OUTPUT (DELAYED SAMPLE CLOCK)

582   581   585   584   589   589A   588   589C   589E

583   586   587   589B   589D   589F

÷M

589H   589G

## Fig. 3B

350   610   600   620

D   Q   TO TRIGGER PROCESSING CIRCUITRY

650   630

R

590   640

## Fig. 4

*Fig. 5*

350

590

620

*Fig. 7*

740

770

790

780

EP 0 444 875 B1

*Fig. 6*

TRIG ARM

350

TO 890

_Fig. 8_

TRIG ARM

890

930

910

920

870

880

900

D    S

     Q

     R

RESET FROM
MICROPROCESSOR
OR TIMEBASE

_Fig. 9_

START — 940

OBTAIN TIME VALUE FOR LEFT SIDE OF SCREEN, "$t_{LEFT}$" — 950

OBTAIN TIME VALUE FOR RIGHT SIDE OF SCREEN, "$t_{RIGHT}$" — 960

OBTAIN CALIBRATION VALUE FOR TRIGGER DELAY, "$t_{(t-s)}$" — 970

DETERMINE VALUE FOR THE START(STOP) PULSES, "$DELAY_{START(STOP)}$" = $t_{LEFT(RIGHT)} \mp t_{(t-s)}$ MOD $\frac{1}{F_S}$ — 980

990 — IS $\frac{1}{4F_S} \leq$ $DELAY_{START(STOP)}$ = $\leq \frac{3}{4F_S}$ ?

NO — TRIGGER $DELAY_{START(STOP)}$ ON FALLING EDGE OF THE SAMPLE CLOCK — 1020

YES

1000 — TRIGGER DELAY ON RISING EDGE OF SAMPLE CLOCK AND SET $DELAY_{START(STOP)}$ TO DETERMINED VALUE

1030 — IS $DELAY_{START(STOP)}$ $< \frac{1}{4F_S}$ ?

NO — SET $DELAY_{NEW}$ = $DELAY_{START(STOP)}$ — 1040

YES

STOP — 1010

SET $DELAY_{NEW}$ = $DELAY_{START(STOP)} + \frac{1}{F_S}$ — 1050

*Fig. 10*

28

_Fig. 11_

```
        ( START )———1060
             │
             ▼
┌─────────────────────────────┐
│      PROGRAM START           │
│    DELAY GEN. TO 0           │
│  (positive edged trigger)    │———1070
│    STOP DELAY GEN. TO 0      │
│  (negative edged trigger)    │
└─────────────────────────────┘
             │
             ▼
┌─────────────────────────────┐
│       BUILD FIRST            │
│      HISTOGRAM AND           │
│  DETERMINE "START(1)"        │———1080
│    AND "STOP(1)"             │
└─────────────────────────────┘
             │
             ▼
┌─────────────────────────────┐
│      PROGRAM START           │
│   DELAY GEN. TO 255          │
│  (positive edged trigger)    │———1090
│   STOP DELAY GEN. TO 255     │
│  (negative edged trigger)    │
└─────────────────────────────┘
             │
             ▼
┌─────────────────────────────┐
│      BUILD SECOND            │
│      HISTOGRAM AND           │
│  DETERMINE "START(2)"        │———1100
│    AND "STOP(2)"             │
└─────────────────────────────┘
             │
             ▼
┌─────────────────────────────┐
│      PROGRAM START           │
│    DELAY GEN. TO 0           │
│  (negative edged trigger)    │———1110
│    STOP DELAY GEN. TO 0      │
│  (positive edged trigger)    │
└─────────────────────────────┘
             │
             ▼
┌─────────────────────────────┐
│       BUILD THIRD            │
│      HISTOGRAM AND           │
│  DETERMINE "START(3)"        │———1120
│    AND "STOP(3)"             │
└─────────────────────────────┘
             │
             ▼
```

—1130

SOLVE :
{
gain(start) *0 + offset(start,positive) = START(1)
gain(start) *255 + offset(start,positive) = START(2)
gain(start) *0 + offset(start,negative) = START(3)
}

{
gain(stop) *0 + offset(stop,negative) = STOP(1)
gain(stop) *255 + offset(stop,negative) = STOP(2)
gain(stop) *0 + offset (stop,positive) = STOP(3)
}

( STOP )———1140